# EUROPÄISCHE PATENTSCHRIFT

(11) **EP 3 160 976 B1**
(45) Veröffentlichungstag und Bekanntmachung des Hinweises auf die Patenterteilung: **24.07.2019**
(21) Anmeldenummer: 15726545.5
(22) Anmeldetag: 03.06.2015
(51) Int. Cl.: C07F 15/00, C09K 11/06, H01L 51/50, H01L 51/00

(54) **METALLKOMPLEXE**
METAL COMPLEXES
COMPLEXES MÉTALLIQUES

(30) Priorität: 30.06.2014 EP 14002238
(43) Veröffentlichungstag der Anmeldung: 03.05.2017
(73) Patentinhaber: Merck Patent GmbH, 64293 Darmstadt (DE)
(72) Erfinder: KOENEN, Nils, 64347 Griesheim (DE); HAYER, Anna, 64293 Darmstadt (DE); HEIL, Holger, 60389 Frankfurt am Main (DE); STOESSEL, Philipp, 60389 Frankfurt am Main (DE)
(86) Internationale Anmeldenummer: PCT/EP2015/001126
(87) Internationale Veröffentlichungsnummer: WO 2016/000803

(56) Entgegenhaltungen:
- WO-A1-2011/013843
- WO-A1-2011/013843
- WO-A1-2011/070990
- WO-A1-2012/023947
- WO-A2-2004/045000
- WO-A2-2011/059719
- JP-A- 2011 219 443
- US-A1- 2009 104 472
- DATABASE CAPLUS [Online] CHEMICAL ABSTRACTS SERVICE, COLUMBUS, OHIO, US; 2012, XP002742719, gefunden im STN Database accession no. 2012:1298450
- AKIHIRO NAKAGAWA ET AL: "Synthesis and Photochemical Properties of pH Responsive Tris-Cyclometalated Iridium(III) Complexes That Contain a Pyridine Ring on the 2-Phenylpyridine Ligand", INORGANIC CHEMISTRY, Bd. 53, Nr. 1, 6. Januar 2014 (2014-01-06) , Seiten 409-422, XP55202475, ISSN: 0020-1669, DOI: 10.1021/ic402387b

## Beschreibung

Die vorliegende Erfindung betrifft Metallkomplexe, welche sich für den Einsatz als Emitter in organischen Elektrolumineszenzvorrichtungen eignen.

In organischen Elektrolumineszenzvorrichtungen (OLEDs) werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer. Dies gilt insbesondere für OLEDs, welche im kürzerwelligen Bereich, also grün und insbesondere blau, emittieren.

Gemäß dem Stand der Technik werden in phosphoreszierenden OLEDs als Triplettemitter vor allem Iridiumkomplexe eingesetzt. Als Iridiumkomplexe werden insbesondere bis- und tris-ortho-metallierte Komplexe mit aromatischen Liganden eingesetzt, wobei die Liganden über ein negativ geladenes Kohlenstoffatom und ein neutrales Stickstoffatom an das Metall binden. Beispiele für solche Komplexe sind das grün emittierende Tris(phenylpyridyl)iridium(III) und Derivate davon (z. B. gemäß US 2002/0034656 oder WO 2010/027583). Aus der Literatur ist eine Vielzahl verwandter Liganden und Iridiumkomplexe bekannt, wie beispielsweise rot emittierende Komplexe mit 1- oder 3-Phenylisochinolinliganden (z. B. gemäß EP 1348711 oder WO 2011/028473) oder mit 2-Phenylchinolinen (z. B. gemäß WO 2002/064700 oder WO 2006/095943) Auch wenn mit derartigen Metallkomplexen bereits gute Ergebnisse erzielt werden, sind hier noch weitere Verbesserungen wünschenswert. Dies gilt insbesondere in Bezug auf die Löslichkeit der Komplexe, die Quanteneffizienz, sowie auf die Farbkoordinaten von rot emittierenden Komplexen. Insbesondere Komplexe mit Liganden, die auf 1-Phenylisochinolin basieren, sind häufig zu tiefrot, so dass hier weitere Verbesserung bezüglich dem Farbort wünschenswert sind.

Aus WO 2011/013843 ist die Verbindung TM-9 bekannt, welche mit einer Pyridingruppe substituiert ist. Verbindungen, die mit einer Heteroarylgruppe mit zwei oder drei Stickstoffatomen substituiert sind, sind nicht offenbart.

Aus US 2009/0104472 ist die Verbindung 2-9 bekannt, die mit einer 3-Pyridylgruppe und einer Trialkylsilylgruppe substituiert ist. Verbindungen, die mit einer Heteroarylgruppe mit zwei oder drei Stickstoffatomen substituiert sind, sind nicht offenbart.

Aufgabe der vorliegenden Erfindung ist daher die Bereitstellung neuer Metallkomplexe, welche sich als Emitter für die Verwendung in OLEDs eignen. Insbesondere ist es die Aufgabe, Emitter bereitzustellen, welche verbesserte Eigenschaften in Bezug auf Farbkoordinaten und/oder Farbreinheit zeigen.

Überraschend wurde gefunden, dass bestimmte, unten näher beschriebene Iridiumkomplexe, bei denen der Ligand in para-Position zum Iridium mit einer Sechsring-Heteroarylgruppe substituiert ist, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

Ir(L)ₙ(L')ₘ Formel (1)

welche eine Teilstruktur M(L)ₙ der Formel (2) enthält: 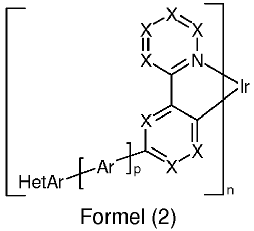 wobei für die verwendeten Symbole und Indizes gilt:
- HetAr: ist eine Gruppe gemäß einer der Formeln (HetAr-1a) bis (HetAr-4a), 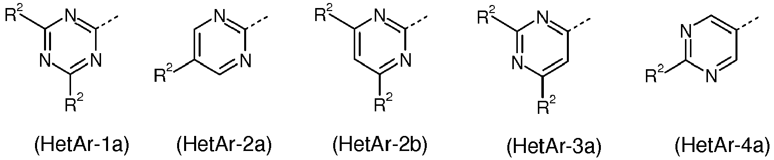 wobei die gestrichelte Bindung die Bindung dieser Gruppe an den Liganden bzw. an Ar andeutet und wobei R² gleich oder verschieden bei jedem Auftreten für ein aromatisches oder heteroaromatisches Ringsystem mit 6 bis 24 aromatischen Ringatomen steht, das jeweils durch einen oder mehrere Reste R³ substituiert sein kann;
- X: ist bei jedem Auftreten CR¹ oder N, mit der Maßgabe, dass maximal zwei Gruppen X pro Cyclus für N stehen, oder zwei direkt aneinander gebundene Gruppen X stehen für eine Gruppe der folgenden Formel (3) oder zwei benachbarte Gruppen X an den beiden unterschiedlichen Cyclen stehen für eine Gruppe der folgenden Formel (4), 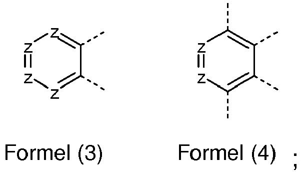 wobei die gestrichelten Bindungen die Verknüpfung dieser Gruppe im Liganden andeuten;
mit der Maßgabe, dass die Teilstruktur der Formel (2) mindestens eine Gruppe der Formel (3) oder (4) enthält;
- Z: ist bei jedem Auftreten CR¹ oder N, mit der Maßgabe, dass maximal zwei Gruppen Z für N stehen;
- Ar: ist eine para-Phenylengruppe, die mit einem oder mehreren Resten R¹ substituiert sein kann;
- R¹: ist bei jedem Auftreten gleich oder verschieden H, D, F, Cl, Br, I, N(R³)₂, CN, NO₂, OH, COOH, C(=O)N(R³)₂, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, C=O, NR³, O, S oder CONR³ ersetzt sein können und wobei ein oder mehrere H-Atome durch D, F, Cl, Br, I oder CN ersetzt sein können, oder ein aromatisches oder heteroaromatisches Ring-system mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann; dabei können zwei benachbarte Reste R¹ bzw. zwei benachbarte Reste R² auch miteinander ein mono- oder polycyclisches, aliphatisches, aromatisches oder heteroaromatisches Ringsystem bilden;
- R³: ist bei jedem Auftreten gleich oder verschieden H, D, F oder eine aliphatische, aromatische und/oder heteroaromatische Gruppe mit 1 bis 20 C-Atomen, in der auch ein oder mehrere H-Atome durch F ersetzt sein können; dabei können zwei oder mehrere Substituenten R³ auch miteinander ein mono- oder polycyclisches, aliphatisches Ringsystem bilden;
- L': ist gleich oder verschieden bei jedem Auftreten ein bidentater, monoanionischer Ligand;
- n: ist 1, 2 oder 3;
- m: ist (3 - n);
- p: ist 0 oder 1.

Dabei ist die Kombination aus einer Teilstruktur der Formel (3) oder (4), also einem ankondensierten aromatischen oder heteroaromatischen Sechsringes, und einer Gruppe (HetAr), also einem Sechsringheteroarylsubstituenten, para zum Iridium erfindungswesentlich.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei weist eine Heteroarylgruppe bevorzugt maximal 3 Heteroatome auf, von denen maximal eines gewählt ist aus O oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bei den Verbindungen der Formel (1) handelt es sich um nicht geladene, d. h. elektrisch neutrale, Verbindungen, da die negative Ladung der Liganden L und L' die Ladung des komplexierten Iridium(III) kompensieren.

Wie oben beschrieben, enthält die erfindungsgemäße Verbindung mindestens eine Gruppe der Formel (3) oder (4). Bevorzugte Ausführungsformen der Teilstruktur der Formel (2) sind somit die Strukturen der folgenden Formeln (5) bis (9), 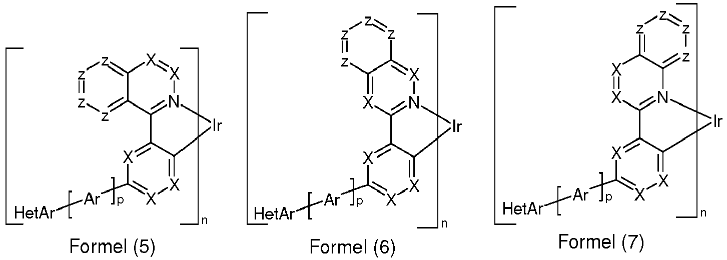 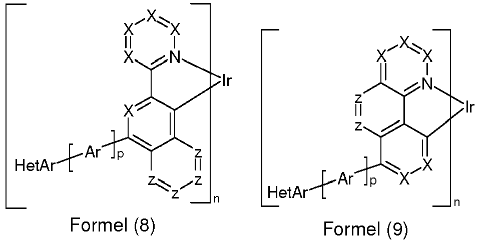 wobei die verwendeten Symbole und Indizes die oben genannten Bedeutungen aufweisen. Dabei enthalten die Strukturen der Formeln (5) bis (8) jeweils eine Struktur der Formel (3), und die Struktur der Formel (9) enthält eine Struktur der Formel (4).

In einer bevorzugten Ausführungsform der Erfindung steht maximal eine Gruppe X pro Cyclus für N. Besonders bevorzugt steht keine der Gruppen X für N.

In einer weiteren bevorzugten Ausführungsform der Erfindung steht maximal eine Gruppe Z für N. Besonders bevorzugt steht keine der Gruppen Z für N.

Besonders bevorzugt stehen alle Gruppen X und alle Gruppen Z gleich oder verschieden bei jedem Auftreten für CR¹.

In einer weiteren bevorzugten Ausführungsform der Erfindung steht Ar für eine unsubstituierte para-Phenylengruppe. Besonders bevorzugt ist p = 0, und die Gruppe Ar ist nicht vorhanden, d. h. die Gruppe HetAr ist direkt an den Liganden gebunden.

Bevorzugte Ausführungsformen der Teilstrukturen der Formeln (5) bis (9) sind somit die Teilstrukturen der folgenden Formeln (5a) bis (9a), 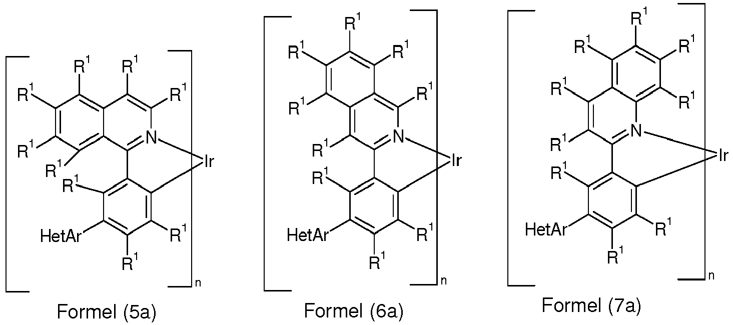 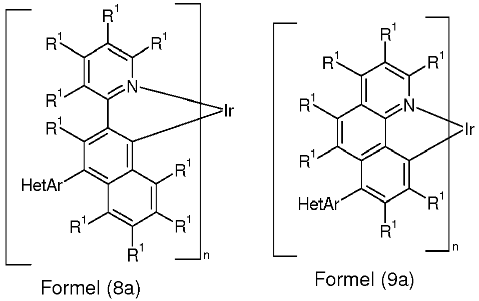 wobei die verwendeten Symbole und Indizes die oben genannten Bedeutungen aufweisen.

Dabei ist es für die Verbindungen enthaltend eine Teilstruktur der Formel (7), (7a), (8) und (8a) bevorzugt, wenn n = 2 ist und L' für einen nicht-ortho-metallierten Liganden, insbesondere für die Diketonat, beispielsweise Acetylacetonat, steht, wie er hinten ausführlich beschrieben wird.

Für die Verbindungen enthaltend eine Teilstruktur der Formeln (5), (6), (9), (5a), (6a) und (9a) ist es bevorzugt, wenn n = 3 ist und entsprechend L' nicht vorhanden ist. Weiterhin ist es für diese Verbindungen bevorzugt, wenn n = 2 ist und L' für einen ortho-metallierten Liganden steht, wie er hinten ausführlich beschrieben wird.

Wie oben beschrieben, ist es erfindungswesentlich, dass die erfindungsgemäße Verbindung para zum Iridiumatom eine heteroaromatische Gruppe HetAr aufweist, die entweder direkt oder über eine Gruppe Ar an den Liganden gebunden ist.

Bevorzugte Reste R¹ an den Gruppen der Formeln (HetAr-1a) bis (HetAr-4a) sind ausgewählt aus Phenyl, Biphenyl, insbesondere ortho-, meta- oder para-Biphenyl, Terphenyl, insbesondere ortho-, meta-, para- oder verzweigtes Terphenyl, Quaterphenyl, insbesondere ortho-, meta-, para- oder verzweigtes Quaterphenyl, Fluorenyl, insbesondere 1-, 2-, 3- oder 4-Fluoren, Spirobifluorenyl, insbesondere 1-, 2-, 3- oder 4-Spirobifluoren, Dibenzofuranyl, insbesondere 1-, 2-, 3- oder 4-Dibenzofuran, oder Carbazolyl, insbesondere 1-, 2-, 3- oder 4-Carbazol, wobei diese Gruppen jeweils durch einen oder mehrere Reste R³ substituiert sein können.

Ganz besonders bevorzugt sind die Gruppen (HetAr-1a) und (HetAr-2b).

Wenn in der Teilstruktur der Formel (2) Reste R¹ gebunden sind, so sind diese Reste R¹ bei jedem Auftreten gleich oder verschieden bevorzugt ausgewählt aus der Gruppe bestehend aus H, D, F, N(R³)₂, CN, B(OR³)₂, C(=O)R³, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R³ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R³ substituiert sein kann; dabei können zwei benachbarte Reste R¹ auch miteinander ein mono- oder polycyclisches, aliphatisches oder aromatisches Ringsystem bilden. Besonders bevorzugt sind diese Reste R¹ bei jedem Auftreten gleich oder verschieden ausgewählt aus der Gruppe bestehend aus H, D, F, N(R³)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R³ substituiert sein kann; dabei können zwei benachbarte Reste R¹ auch miteinander ein mono- oder polycyclisches, aliphatisches oder aromatisches Ringsystem bilden.

Wenn mehrere Reste R¹ im Liganden L miteinander ein Ringsystem bilden, was zu einem ankondensierten Ringsystem führt, so ist es weiterhin bevorzugt, wenn diese Ringbildung zu einer ankondensierten aliphatischen Ringstruktur führt, die keine aziden benzylischen Protonen aufweist, insbesondere eine Fünfring-, Sechsring- oder Siebenringstruktur bzw. eine bicyclische Struktur. Eine solche Ringbildung ist beispielsweise in WO 2014/023377 sowie den noch nicht offen gelegten Anmeldungen EP 13004411.8, EP 14000345.0 und EP 14000417.7 ausführlich beschrieben, und der Fachmann kann diese Lehre ohne erfinderisches Zutun auch auf die vorliegenden erfindungsgemäßen Verbindungen übertragen.

Im Folgenden werden bevorzugte Liganden L' beschrieben, wie sie in Formel (1) vorkommen.

Die Liganden L' sind bevorzugt monoanionische bidentate Liganden, die über ein Stickstoffatom und ein Kohlenstoffatom oder über zwei Sauerstoffatome oder über zwei Stickstoffatome oder über ein Stickstoffatom und ein Sauerstoffatom an Ir binden.

Bevorzugte Liganden L' sind ausgewählt aus 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylaten, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, oder Salicyliminaten abgeleitet von Salicyliminen, wie z. B. Methylsalicylimin, Ethylsalicylimin, Phenylsalicylimin.

Bevorzugt sind weiterhin bidentate monoanionische Liganden L', welche mit dem Iridium einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R¹ substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (10) bis (34) dargestellt sind, wobei eine Gruppe bevorzugt über ein neutrales Stickstoffatom oder ein Carbenkohlenstoffatom bindet und die andere Gruppe bevorzugt über ein negativ geladenes Kohlenstoffatom oder ein negativ geladenes Stickstoffatom bindet. Der Ligand L' kann dann aus den Gruppen der Formeln (10) bis (34) gebildet werden, indem diese Gruppen jeweils an der durch # gekennzeichneten Position aneinander binden. Die Position, an der die Gruppen an das Metall koordinieren, sind durch * gekennzeichnet.

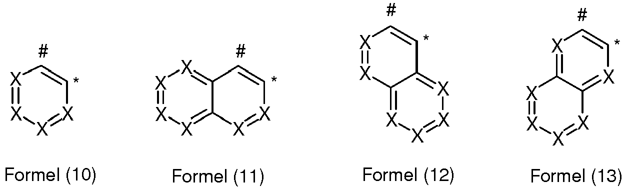

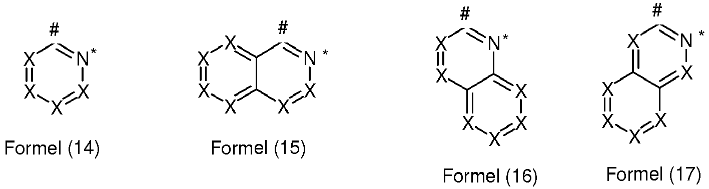

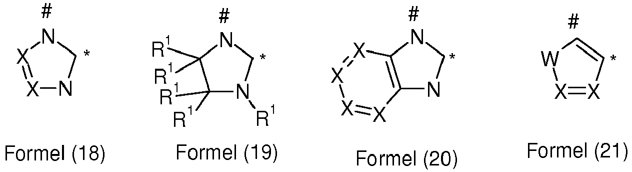

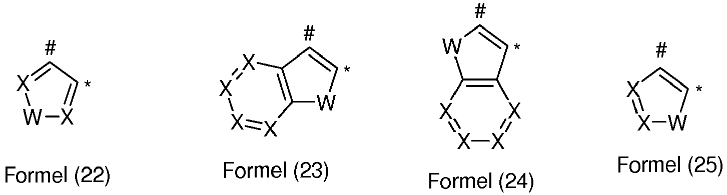

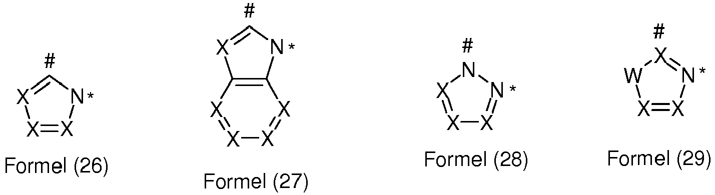

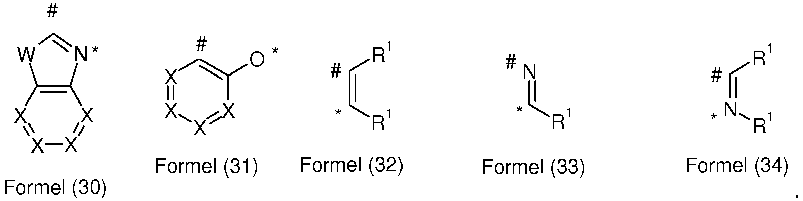

Dabei steht W gleich oder verschieden bei jedem Auftreten für NR¹, O oder S, und X steht bei jedem Auftreten gleich oder verschieden für CR¹ oder N, wobei maximal zwei Gruppen X pro Cyclus für N stehen, und R¹ hat dieselbe Bedeutung wie oben beschrieben. Bevorzugt steht maximal ein Symbol X in jeder Gruppe für N. Insbesondere bevorzugt stehen alle Symbole X für CR.

Wenn zwei Reste R¹ im Liganden L', die an zwei unterschiedlichen Cyclen der oben genannten Formeln (10) bis (34) gebunden sind, miteinander ein aromatisches Ringsystem bilden, können sich beispielsweise Liganden ergeben, die insgesamt eine einzige größere Heteroarylgruppe darstellen, wie beispielsweise Benzo[h]chinolin, etc.. Bevorzugte Liganden L', die durch Ringbildung zweier Reste R an den unterschiedlichen Cyclen entstehen, sind die im Folgenden aufgeführten Strukturen der Formeln (35) bis (39), 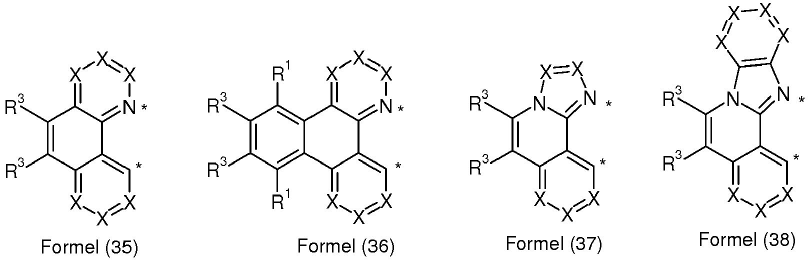 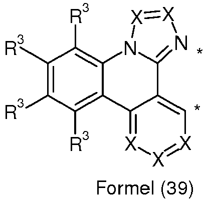 wobei die verwendeten Symbole die oben genannten Bedeutungen aufweisen.

Bevorzugte Reste R¹ in den oben aufgeführten Strukturen von L' sind bei jedem Auftreten gleich oder verschieden ausgewählt aus der Gruppe bestehend aus H, D, F, N(R³)₂, CN, B(OR³)₂, C(=O)R³, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten R³ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste R³ substituiert sein kann; dabei können zwei oder mehrere benachbarte Reste R¹ auch miteinander ein mono- oder polycyclisches, aliphatisches, aromatisches und/oder benzoannelliertes Ringsystem bilden. Besonders bevorzugte Reste R¹ sind bei jedem Auftreten gleich oder verschieden ausgewählt aus der Gruppe bestehend aus H, D, F, CN, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R³ substituiert sein kann; dabei können zwei oder mehrere Reste R¹ auch miteinander ein mono- oder polycyclisches, aliphatisches, aromatisches und/oder benzoannelliertes Ringsystem bilden.

Wenn mehrere Reste R¹ im Liganden L' miteinander ein Ringsystem bilden, was zu einem ankondensierten Ringsystem führt, so ist es weiterhin bevorzugt, wenn diese Ringbildung zu einer ankondensierten aliphatischen Ringstruktur führt, die keine aziden benzylischen Protonen aufweist, insbesondere eine Fünfring-, Sechsring- oder Siebenringstruktur bzw. eine bicyclische Struktur. Eine solche Ringbildung ist beispielsweise in WO 2014/023377 sowie den noch nicht offen gelegten Anmeldungen EP 14000345.0 und EP 14000417.7 ausführlich beschrieben, und der Fachmann kann diese Lehre ohne erfinderisches Zutun auch auf die vorliegenden erfindungsgemäßen Verbindungen übertragen.

Die erfindungsgemäßen Komplexe können facial bzw. pseudofacial sein, oder sie können meridional bzw. pseudomeridional sein.

Die Liganden L und/oder L' können je nach Struktur auch chiral sein. Dies ist insbesondere dann der Fall, wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für geeignete Verbindungen gemäß Formel (1) sind die in der folgenden Tabelle aufgeführten Strukturen.

| | | |
|---|---|---|
| 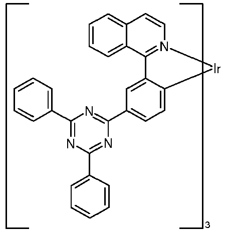 | 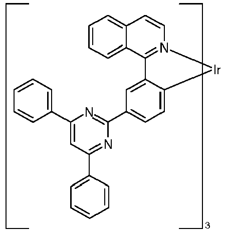 | |
| 1 | 2 | |
| 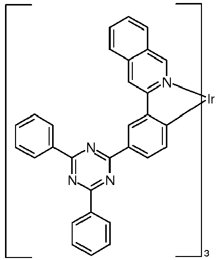 | 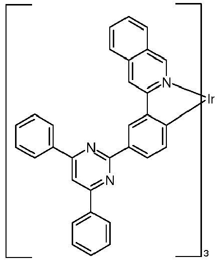 | |
| 4 | 5 | |
| 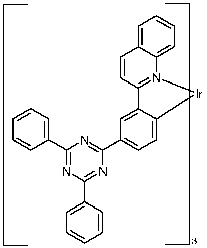 | 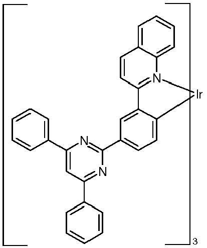 | |
| 7 | 8 | |
| 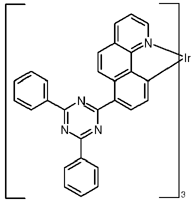 | 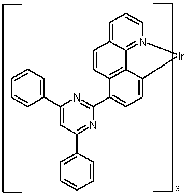 | |
| 10 | 11 | |
| 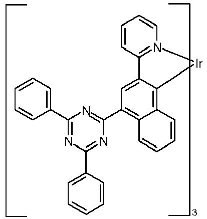 | 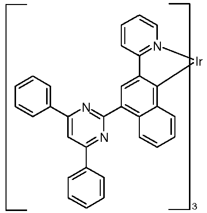 | |
| 13 | 14 | |
| 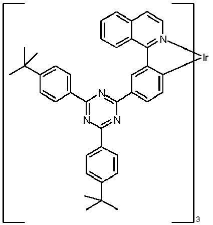 | 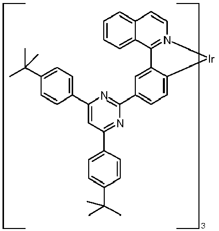 | |
| 16 | 17 | |
| 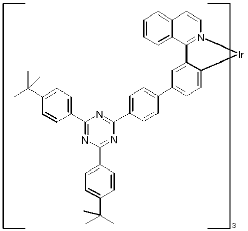 | 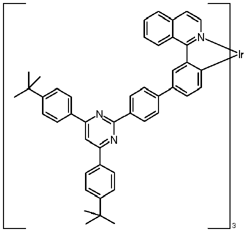 | |
| 19 | 20 | |
| 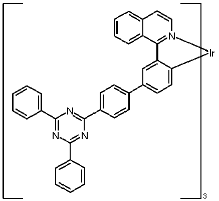 | 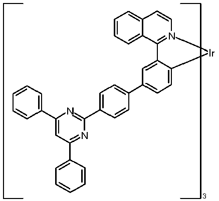 | |
| 22 | 23 | |
| 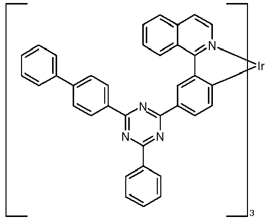 | 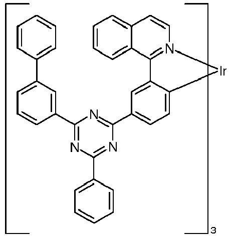 | 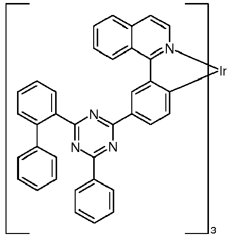 |
| 25 | 26 | 27 |
| 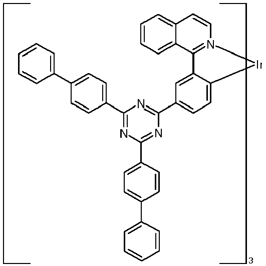 | 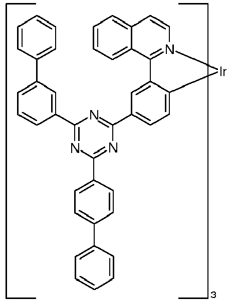 | 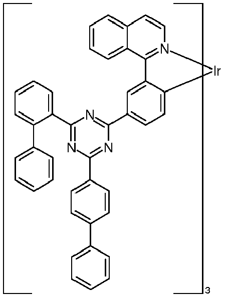 |
| 28 | 29 | 30 |
| 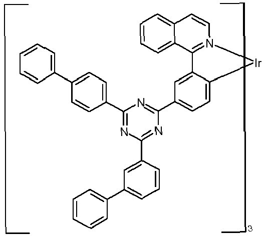 | 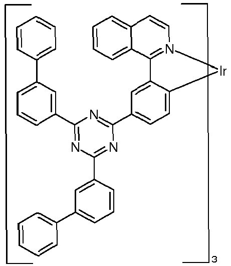 | 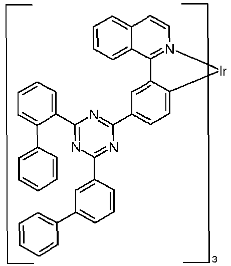 |
| 31 | 32 | 33 |
| 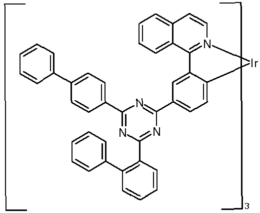 | 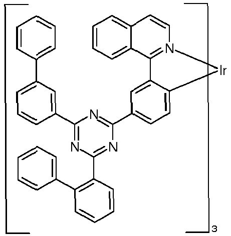 | 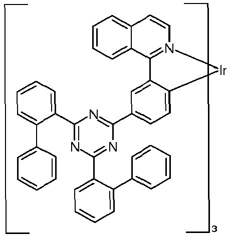 |
| 34 | 35 | 36 |
| 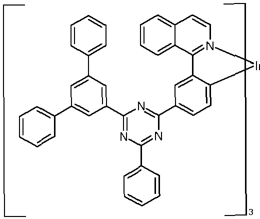 | 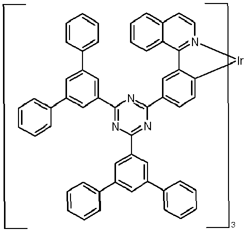 | 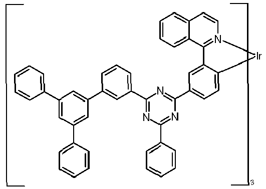 |
| 37 | 38 | 39 |
| 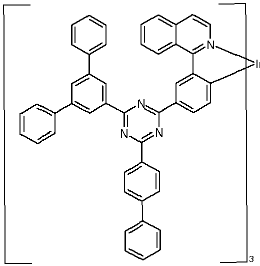 | 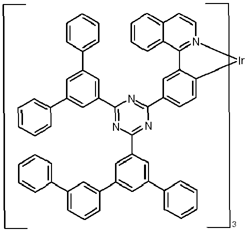 | 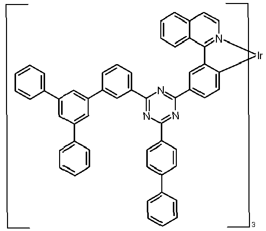 |
| 40 | 41 | 42 |
| 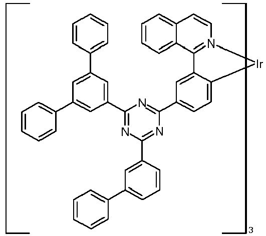 | 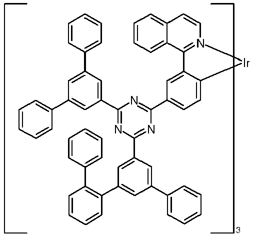 | 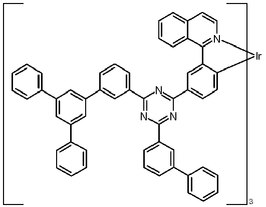 |
| 43 | 44 | 45 |
| 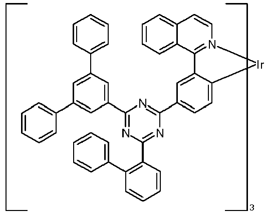 | 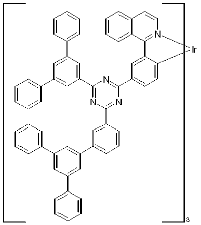 | 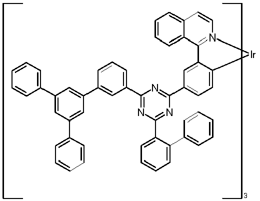 |
| 46 | 47 | 48 |
| 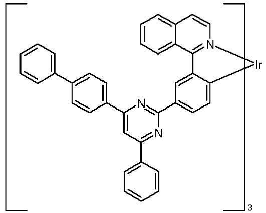 | 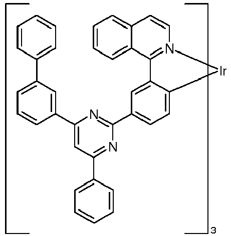 | 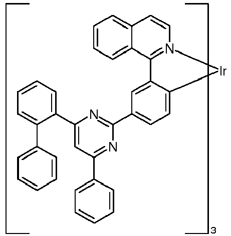 |
| 49 | 50 | 51 |
| 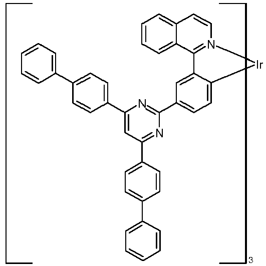 | 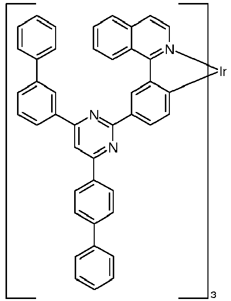 | 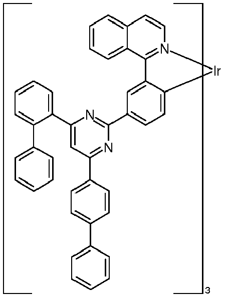 |
| 52 | 53 | 54 |
| 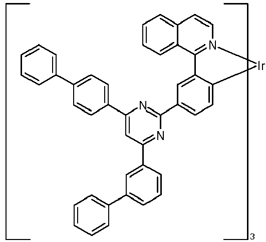 | 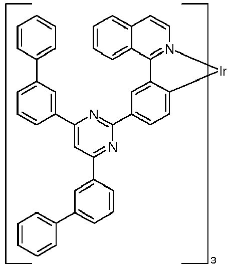 | 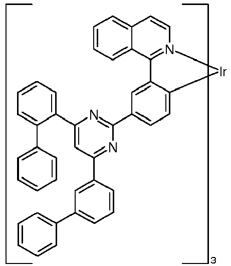 |
| 55 | 56 | 57 |
| 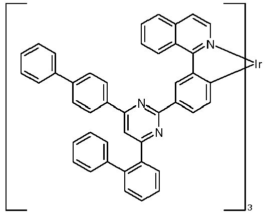 | 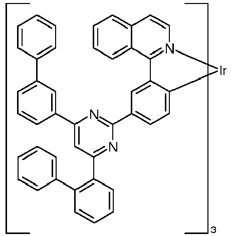 | 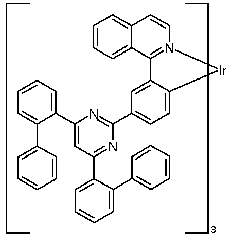 |
| 58 | 59 | 60 |
| 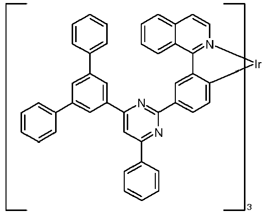 | 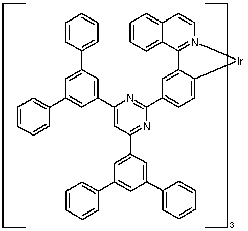 | 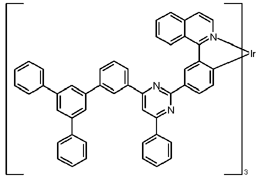 |
| 61 | 62 | 63 |
| 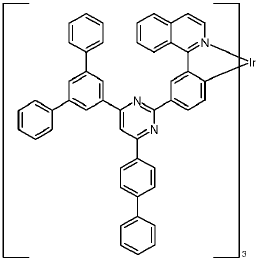 | 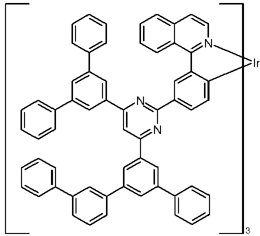 | 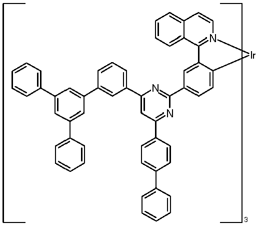 |
| 64 | 65 | 66 |
| 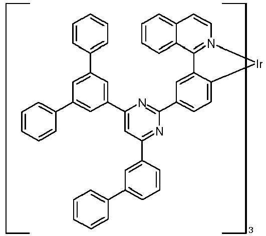 | 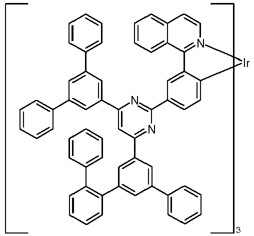 | 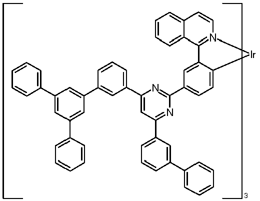 |
| 67 | 68 | 69 |
| 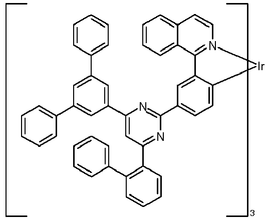 | 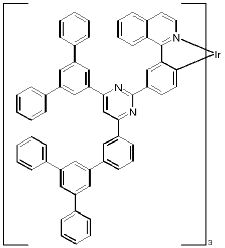 | 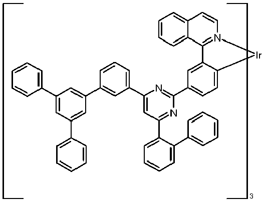 |
| 70 | 71 | 72 |
| 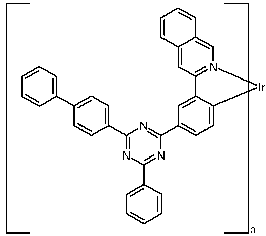 | 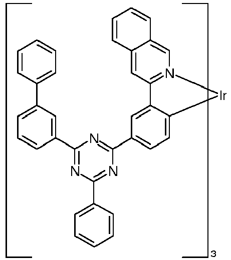 | 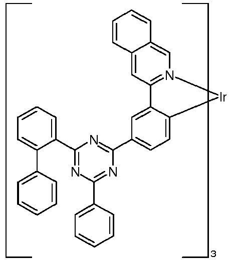 |
| 73 | 74 | 75 |
| 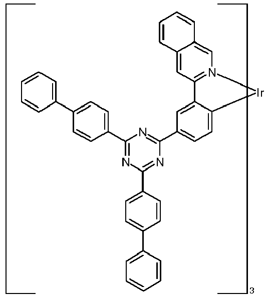 | 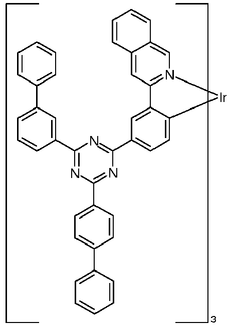 | 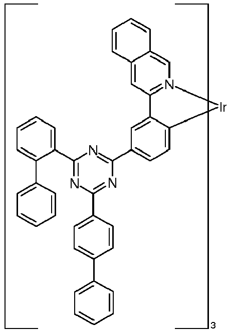 |
| 76 | 77 | 78 |
| 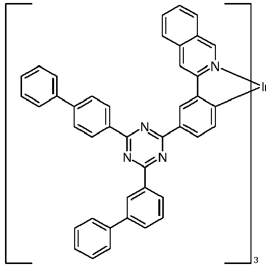 | 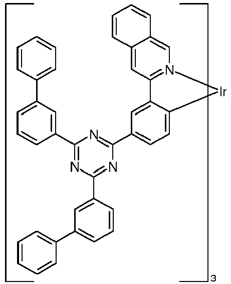 | 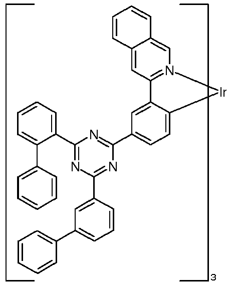 |
| 79 | 80 | 81 |
| 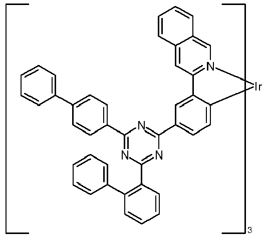 | 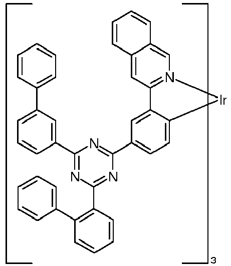 | 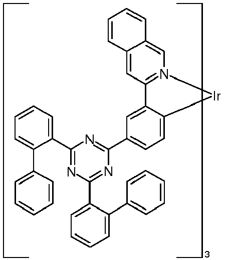 |
| 82 | 83 | 84 |
| 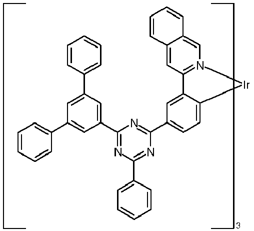 | 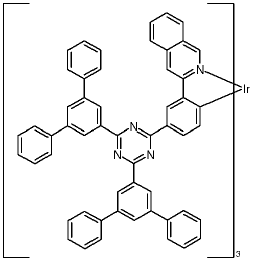 | 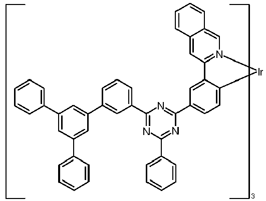 |
| 85 | 86 | 87 |
| 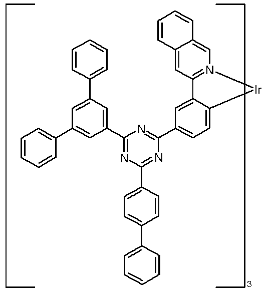 | 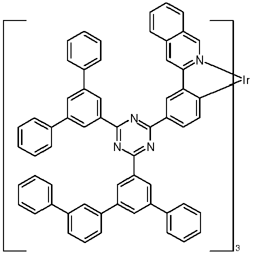 | 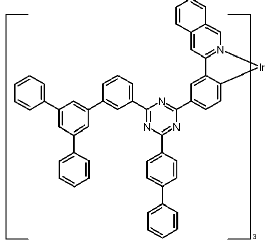 |
| 88 | 89 | 90 |
| 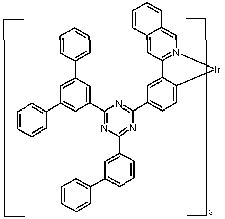 | 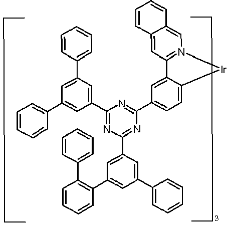 | 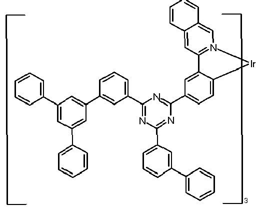 |
| 91 | 92 | 93 |
| 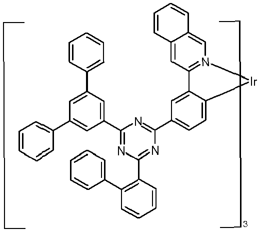 | 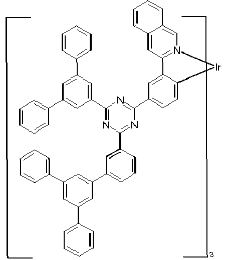 | 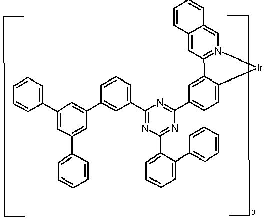 |
| 94 | 95 | 96 |
| 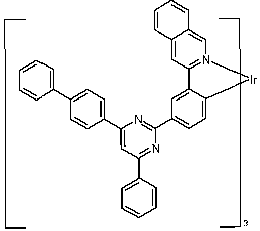 | 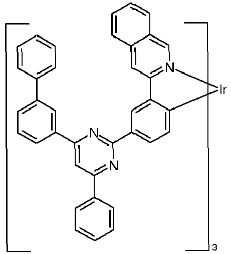 | 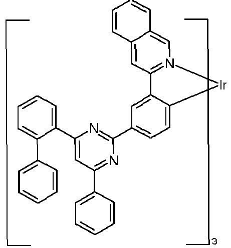 |
| 97 | 98 | 99 |
| 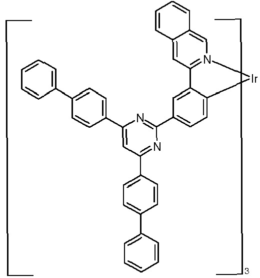 | 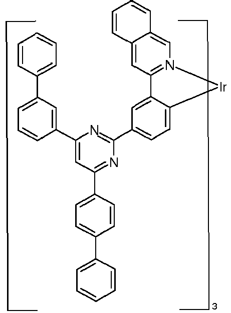 | 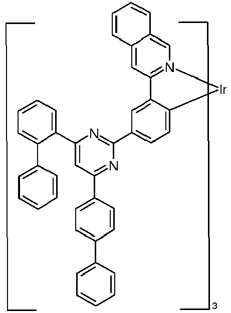 |
| 100 | 101 | 102 |
| 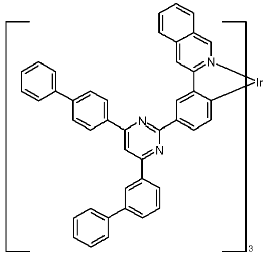 | 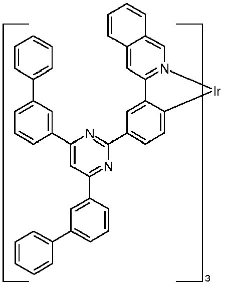 | 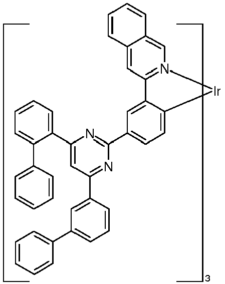 |
| 103 | 104 | 105 |
| 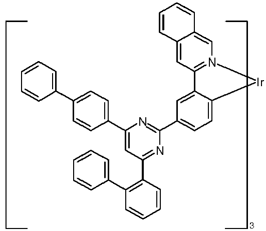 | 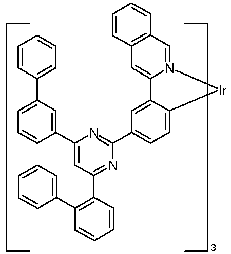 | 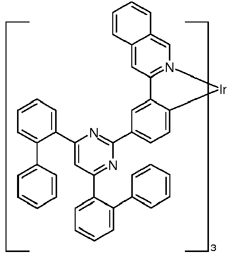 |
| 106 | 107 | 108 |
| 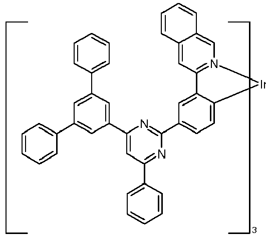 | 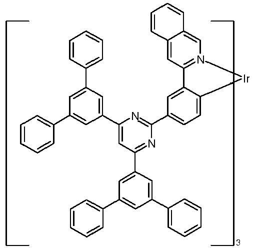 | 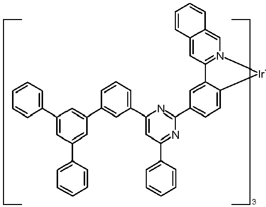 |
| 109 | 110 | 111 |
| 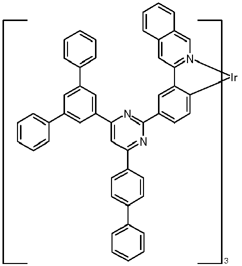 | 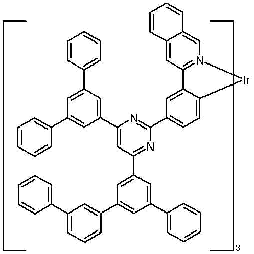 | 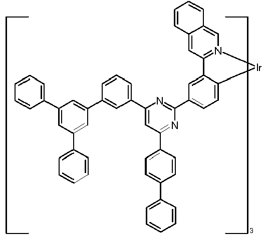 |
| 112 | 113 | 114 |
| 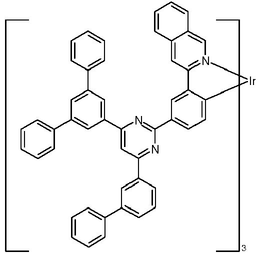 | 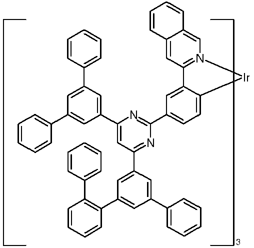 | 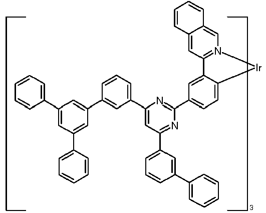 |
| 115 | 116 | 117 |
| 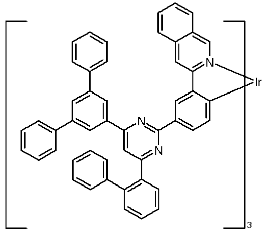 | 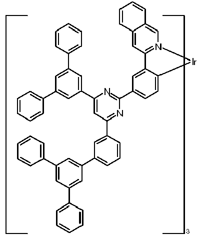 | 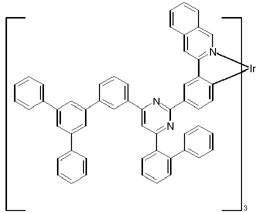 |
| 118 | 119 | 120 |
| 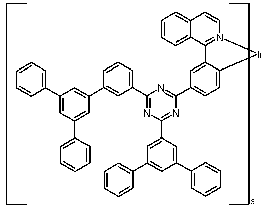 | 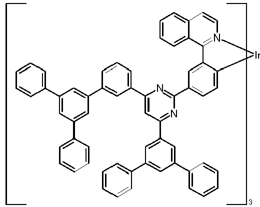 | |
| 121 | 122 | |
| 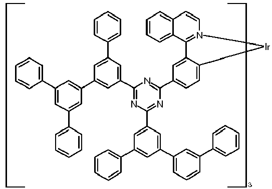 | 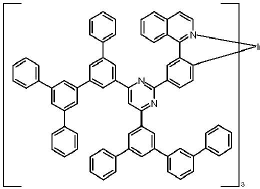 | |
| 124 | 125 | |
| 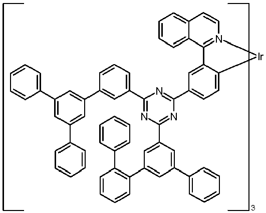 | 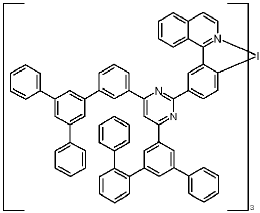 | |
| 127 | 128 | |
| 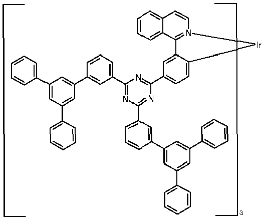 | 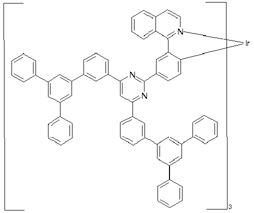 | |
| 130 | 131 | |
| 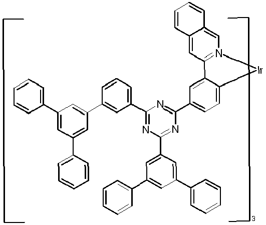 | 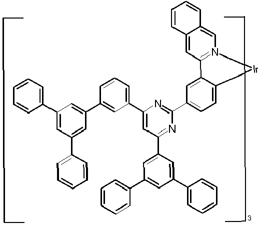 | |
| 133 | 134 | |
| 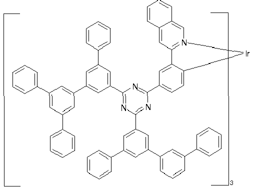 | 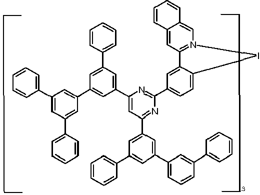 | |
| 136 | 137 | |
| 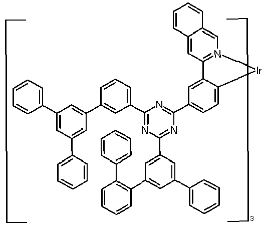 | 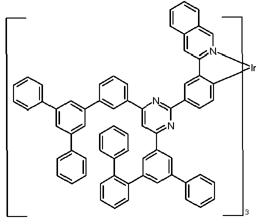 | |
| 139 | 140 | |
| 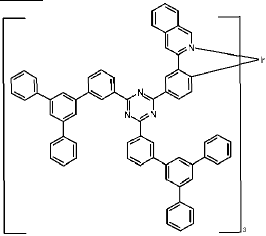 | 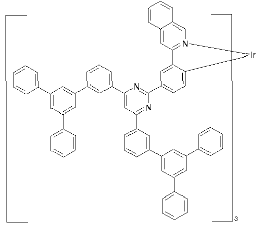 | |
| 142 | 143 | |

Die erfindungsgemäßen Metallkomplexe sind prinzipiell durch verschiedene Verfahren darstellbar. So ist es möglich, als Edukt einen Metallkomplex einzusetzen, der die gleiche Zusammensetzung wie die erfindungsgemäße Verbindung aufweist, jedoch statt der Gruppe HetAr eine reaktive Abgangsgruppe aufweist, beispielsweise ein Halogen, insbesondere Chlor, Brom oder lod, oder eine Boronsäure bzw. einen Boronsäureester. Wenn das Edukt eine Halogengruppe aufweist, so wird diese zunächst, beispielsweise durch Palladium-katalysierte Umsetzung mit Bis-(pinacolato)diboran, in ein entsprechendes Boronsäurederivat umgewandelt. Dieses wird dann in einer Suzuki-Kupplungsreaktion unter Palladium-Katalyse mit einer Verbindung HetAr-Hal, wobei Hal für ein Halogen, insbesondere Chlor oder Brom steht, zu der erfindungsgemäßen Verbindung der Formel (1) umgesetzt. Dies ist schematisch im Folgenden dargestellt: 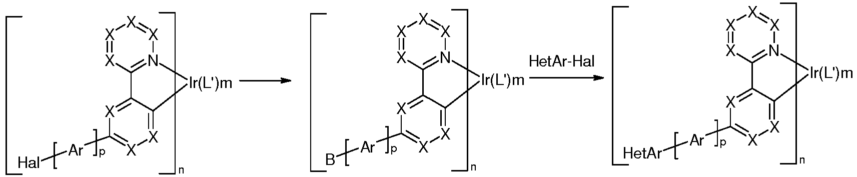 wobei Hal für ein Halogen, insbesondere Chlor, Brom oder lod, steht und B für eine Boronsäure oder einen Boronsäureester.

Weiterhin geeignet ist ein Verfahren zur Herstellung der Verbindungen gemäß Formel (1) durch Umsetzung der entsprechenden freien Liganden L und gegebenenfalls L' mit Iridiumalkoholaten der Formel (40), mit Iridiumketoketonaten der Formel (41), mit Iridiumhalogeniden der Formel (42), mit dimeren Iridiumkomplexen der Formel (43) oder mit Iridiumkomplexen der Formel (44),

lr(OR¹)ₙ Formel (40)

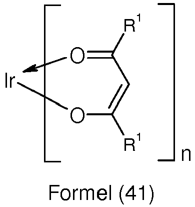

IrHalₙ Formel (42)

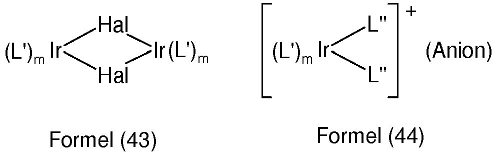

wobei die Symbole und Indizes m, n und R¹ die oben angegebenen Bedeutungen haben, Hal = F, Cl, Br oder I ist, L" für einen Alkohol, insbesondere für einen Alkohol mit 1 bis 4 C-Atomen oder ein Nitril, insbesondere Acetonitril oder Benzonitril, steht und (Anion) ein nichtkoordinierendes Anion ist, wie beispielsweise Triflat.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese kann auch durch Umsetzung der Liganden L mit Iridiumkomplexen der Formel [Ir(L')₂(HOMe)₂]A oder [Ir(L')₂(NCMe)₂]A oder durch Umsetzung der Liganden L' mit Iridiumkomplexen der Formel [Ir(L)₂(HOMe)₂]A oder [Ir(L)₂(NCMe)₂]A, wobei A jeweils ein nicht koordinierendes Anion, wie z. B. Triflat, Tetrafluoroborat, Hexafluorophosphat, etc., darstellt, in dipolar-protischen Lösungsmitteln, wie z. B. Ethylenglykol, Propylenglykol, Glycerin, Diethylenglykol, Triethylenglykol, etc., durchgeführt werden.

Die Synthese der Komplexe wird bevorzugt durchgeführt wie in WO 2002/060910 und in WO 2004/085449 beschrieben. Heteroleptische Komplexe können beispielsweise auch gemäß WO 05/042548 synthetisiert werden. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMOS) oder Sulfone (Dimethylsulfon, Sulfolan, etc.). Geeignete Schmelzhilfen sind Verbindungen, die bei Rautemperatur fest vorliegen, jedoch beim Erwäremen der Reaktionsmischung schmelzen und die Reaktanden lösen, so dass eine homogene Schmelze entsteht. Besonders geeignet sind Biphenyl, m-Terphenyl, Triphenylen, 1,2-, 1,3-, 1,4-Bis-phenoxybenzol, Triphenylphosphinoxid, 18-Krone-6, Phenol, 1-Naphthol, Hydrochinon, etc..

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Bei den erfindungsgemäßen Verbindungen kann auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, die Löslichkeit noch weiter erhöht werden. Lösliche Verbindungen eignen sich besonders gut für die Verarbeitung aus Lösung, beispielsweise durch Druckverfahren.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebenen Verbindungen gemäß Formel (1) bzw. die oben aufgeführten bevorzugten Ausführungsformen können in der elektronischen Vorrichtung als aktive Komponente verwendet werden. Ein weiterer Gegenstand der vorliegenden Erfindung ist somit die Verwendung einer erfindungsgemäßen Verbindung in einer elektronischen Vorrichtung. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 15 Gew.-% der Verbindung gemäß Formel (1) bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 85 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Die erfindungsgemäßen Verbindungen sind insbesondere auch geeignet als phosphoreszierende Emitter in organischen Elektrolumineszenzvorrichtungen, wie sie z. B. in WO 98/24271, US 2011/0248247 und US 2012/0223633 beschrieben sind. In diesen mehrfarbigen Display-Bauteilen wird eine zusätzliche blaue Emissionsschicht vollflächig auf alle Pixel, auch diejenigen mit einer von Blau verschiedenen Farbe, aufgedampft. Dabei wurde gefunden, dass die erfindungsgemäßen Verbindungen, wenn sie als Emitter für das rote Pixel eingesetzt werden, zusammen mit der aufgedampften blauen Emissionsschicht zu sehr guter Emission führen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. Dabei wurde gefunden, dass sich die erfindungsgemäßen Verbindungen sehr gut aus Lösung verarbeiten lassen.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
(1) Die erfindungsgemäßen Verbindungen weisen eine sehr hohe Photolumineszenzquanteneffizienz auf und führen auch bei Verwendung in einer organischen Elektrolumineszenzvorrichtung zu sehr hohen Quanteneffizienzen. Insbesondere sind die Quanteneffizienzen höher im Vergleich zu Metallkomplexen mit Liganden, die die gleiche Ligandengrundstruktur aufweisen, an die jedoch keine Gruppe HetAr gebunden ist.
(2) Die erfindungsgemäßen Verbindungen führen bei Verwendung in einer organischen Elektrolumineszenzvorrichtung zu einer sehr guten Lebensdauer.
(3) Erfindungsgemäße Verbindungen mit 1-Phenylisochinolinliganden weisen eine weniger tiefrote Emission auf im Vergleich zu entsprechenden Metallkomplexen mit 1-Phenylisochinolinliganden, an die keine Gruppe HetAr gebunden ist. Durch die verbesserten Farbkoordinaten eignen sich die erfindungsgemäßen Verbindungen besser als die entsprechenden Verbindungen gemäß dem Stand der Technik für die Verwendung in rot emittierenden organischen Elektrolumineszenzvorrichtungen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von VWR, Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### Synthese von Synthonen

### Darstellung von Synthon S1:

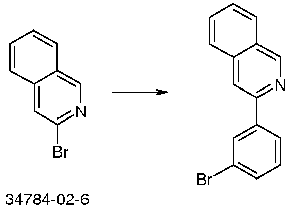

3-Bromisochinolin (20,7 g, 100 mmol), 3-Bromphenylboronsäure (20 g, 100 mmol, CAS: 89598-96-9), Natriumcarbonat (23,2 g, 200 mmol) und Tetrakis(triphenylphosphin)-palladium(0) (1,2 g, 10 mmol) werden in einem 1L-Mehrhalskolben mit 230 ml Dimethoxyethan, 100 ml VE-Wasser und 75 ml Ethanol versetzt und unter Rühren für 10 Minuten inertisiert. Die Reaktionsmischung wird bei 70 °C über Nacht gerührt, abgekühlt auf Raumtemperatur und mit Wasser und Dichlormethan verdünnt. Die organische Phase wird abgetrennt und die wässrige Phase zweimal mit Dichlormethan nachextrahiert. Die organischen Phasen werden vereinigt, mit Wasser gewaschen, über Na₂SO₄ getrocknet und filtriert. Das Lösemittel wird entfernt und der Rückstand aus Acetonitril umkristallisiert, so dass 21,9 g (7,7 mmol, 78% Ausbeute) eines farblosen Pulvers erhalten wird.

### Darstellung von Synthon S2:

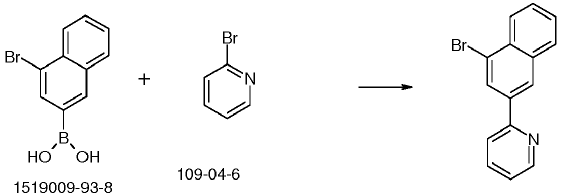

(4-Brom-2-naphthyl)boronsäure (25,1 g, 100 mmol), 2-Brompyridin (15,8 g, 100 mmol), Natriumcarbonat (23,2 g, 200 mmol) und Tetrakis(triphenylphosphin)-palladium(0) (1,2 g, 10 mmol) werden in einem 1L-Mehrhalskolben mit 230 ml Dimethoxyethan, 100 ml VE-Wasser und 75 ml Ethanol versetzt und unter Rühren für 10 Minuten inertisiert. Die Reaktionsmischung wird bei 70 °C über Nacht gerührt, abgeküh It auf Raumtemperatur und mit Wasser und Dichlormethan verdünnt. Die organische Phase wird abgetrennt und die wässrige Phase zweimal mit Dichlormethan nachextrahiert. Die organischen Phasen werden vereinigt, mit Wasser gewaschen, über Na₂SO₄ getrocknet und filtriert. Das Lösemittel wird entfernt und der Rückstand aus Acetonitril umkristallisiert, so dass 19,6 g (69 mmol, 69% Ausbeute) eines farblosen Pulvers erhalten wird.

**Weitere, literaturbekannte Synthone**

| | | |
|---|---|---|
| 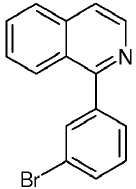 | 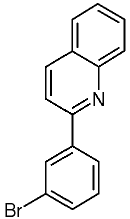 | 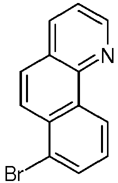 |
| 936498-09-8 | 108062-54-0 | 31493-29-5 |
| **S3** | **S4** | **S5** |

### Umwandlung der Bromide in Pinacolboranester

### Allgemeine Synthesevorschrift zur Herstellung des Pinacolboranesters

In einen 4-Liter-Vierhalskolben mit KPG-Rührer, Rückflusskühler, Schutzgas-Anschluss und Thermometer werden das Arylbromid (880 mmol), Bis(pinacolato)diboran (265 g, 1,044 mol, 1,2 eq.) und Kaliumacetat (260 g, 2,65 mol, 3 eq.) vorgelegt, mit Schutzgas gespült und mit 2 Litern getrocknetem 1,4-Dioxan versetzt. Der Katalysator 1,1-Bis(diphenyl-phosphino)ferrocen-dichloropalladium(II) (3,6 g, 4,4 mmol, 0,005 eq.) wird zugesetzt, und die Reaktionsmischung wird über Nacht bei 110 °C gerührt. Nach dem Abkühlen werden 500 ml Ethylacetat und 500 ml Wasser zugefügt. Die Phasen werden getrennt und die wässrige Phase mit 200 ml Ethylacetat extrahiert. Die organischen Phasen werden vereinigt, mehrfach mit Wasser und gesättigter NaCl-Lösung gewaschen und über Natriumsulfat getrocknet. Das Lösemittel wird am Rotationsverdampfer abgezogen. Der schwarze Feststoff wird in einer Mischung aus Heptan/Ethylacetat gelöst (2:1), über eine Glasfritte mit Kieselgel und Celite filtriert und mit der Lösemittel-Mischung nachgewaschen. Die orange Lösung wird am Rotationsverdampfer vom Lösemittel befreit und der Rückstand aus Heptan umkristallisiert. Es werden farblose Kristalle erhalten.

Analog zur allgemeinen Vorschrift können folgende Synthone hergestellt werden:

| **Bsp.** | **Edukt** | **Produkt** | **Ausbeute** |
|---|---|---|---|
| **S6** | 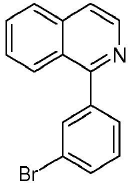 | 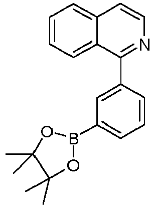 | 91% |
| **S7** | 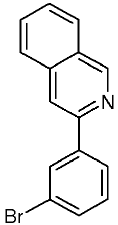 | 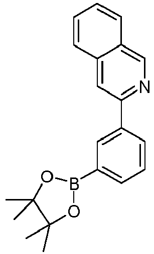 | 87% |
| **S8** | 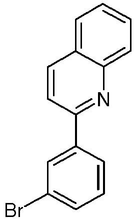 | 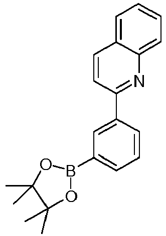 | 83% |
| **S9** | 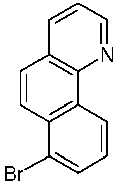 | 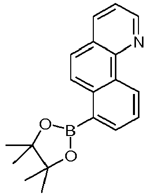 | 88% |
| **S10** | 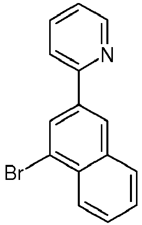 | 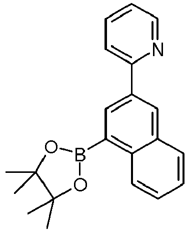 | 92% |

### Synthon S11:

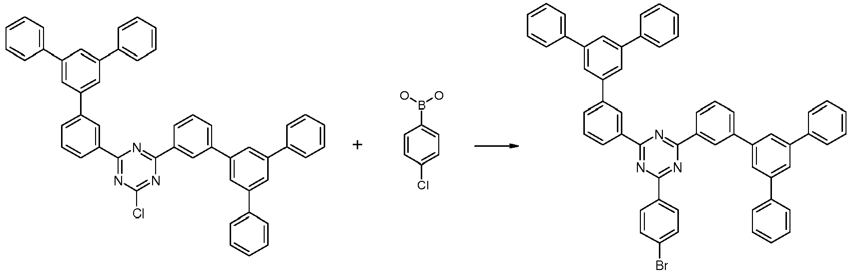

50 g (69 mmol) 2-Chlor-4,6-[3-(3,5-diphenyl)phenyl]-1,3,5-triazin [1233200-61-7] werden mit 10,8 g (69 mmol) (4-Chlorphenyl)boronsäure, 2 g (1,726 mmol) Tetrakis(triphenylphosphin)-palladium(0) und 21 g (152 mmol) Kaliumcarbonat eingewogen und mit 350 ml Toluol, 350 ml Wasser und 350 ml Dioxan vermischt. Die Mischung wird für 24 h unter Rückfluss erhitzt. Nach Abkühlen wird der angefallene Feststoff abgesaugt und per Heißextraktion mit Toluol über neutralem Aluminiumoxid aufgereinigt. Es werden 32 g (58%, 40 mmol) eines farblosen Feststoffes erhalten.

### Synthon S12:

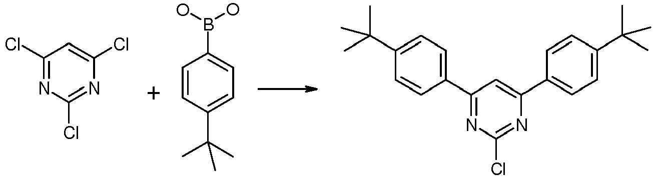

32 g (174 mmol) 2,4,6-Trichlorpyrimidin, 62 g (348 mmol) (4-tert-Butylphenyl)boronsäure, 110 g (1,038 mol) Natriumcarbonat, 1 g (4,454 mmol) Palladium(II)acetat und 2,3 g (8,8 mmol) Triphenylphosphin werden in 450 ml Ethylenglycoldimethylether und 300 ml Wasser gelöst. Die Mischung wird für 6 h auf 70 °C erhitzt. Nach dem A bkühlen wird der ausgefallene Feststoff abdekantiert, in Toluol gelöst und wässrig aufgearbeitet. Das braune Öl wird mit Ethanol heiß ausgerührt und abfiltriert. Es werden 19,8 g (30%, 52 mmol) eines farblosen Feststoffes erhalten.

Folgende Bausteine können mit den Synthonen **S1 - S10** zu Liganden verknüpft werden:

| | | |
|---|---|---|
| 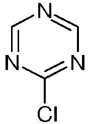 | 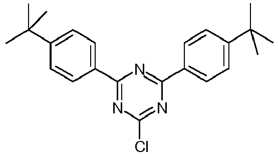 | 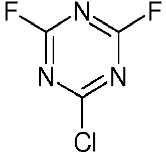 |
| 6153-86-2* | 253158-13-3 | 696-85-5* |
| 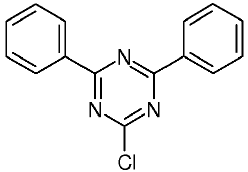 | 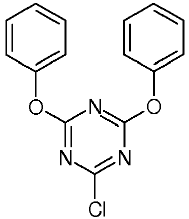 | 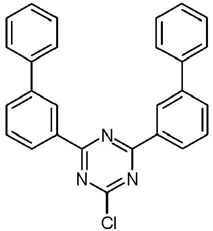 |
| 3842-55-5 | 2972-65-8* | 1205748-61-3 |
| 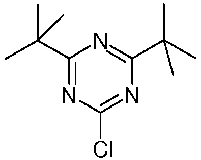 | 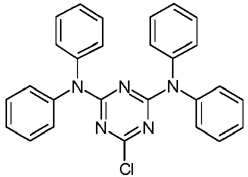 | 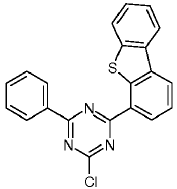 |
| 73084-03-4* | 83820-01-3* | 1476735-48-4 |
| 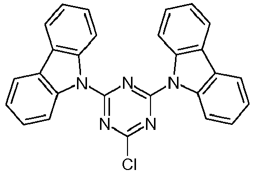 | 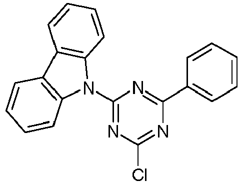 | 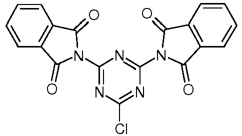 |
| 877615-05-9 | 1268244-56-9 | 19138-11-5* |
| 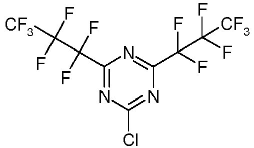 | 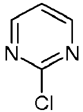 | 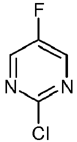 |
| 804-67-1* | 1722-12-9* | 62802-42-0* |
| 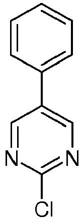 | 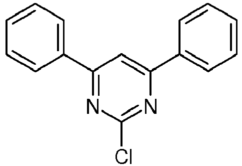 | 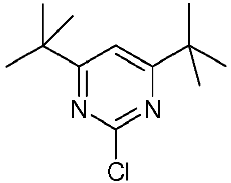 |
| 22536-62-5 | 2915-16-4 | 71162-19-1* |
| 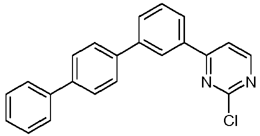 | 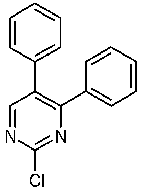 | 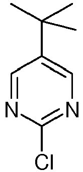 |
| 1383627-88-0* | 39860-32-7* | 156777-81-0* |
| 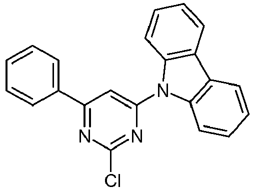 | 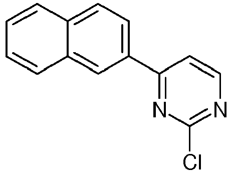 | 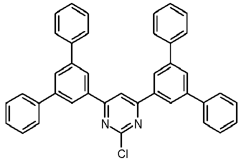 |
| 1426818-83-8 | 488816-96-2* | 1384480-21-0 |
| 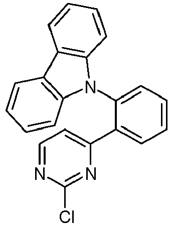 | 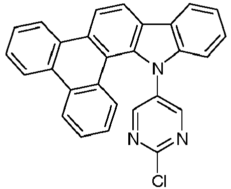 | 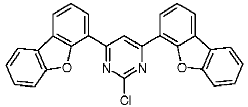 |
| 1413615-86-7* | 1418124-57-8 | 1421599-31-6 |
| 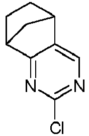 | 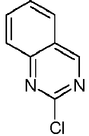 | 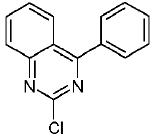 |
| 1037776-03-6* | 6141-13-5* | 529874-83-7* |
| 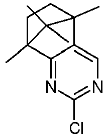 | 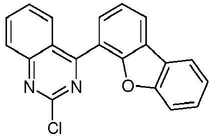 | 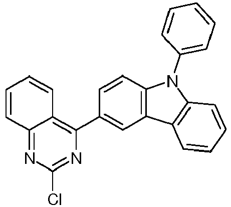 |
| 209409-84-7* | 1403252-54-9* | 1373317-91-9* |
| 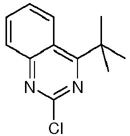 | 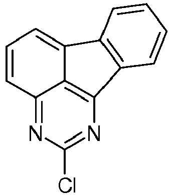 | 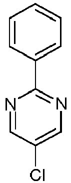 |
| 1092837-92-7* | 666854-39-3* | 34771-50-1 |
| 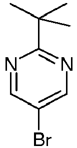 | 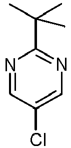 | 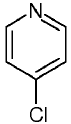 |
| 85929-94-8* | 91167-21-4* | 626-61-9* |
| 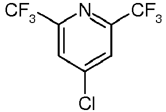 | 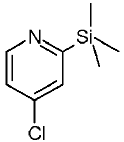 | 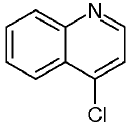 |
| 81269-96-7* | 139585-50-5* | 611-35-8* |
| 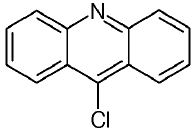 | 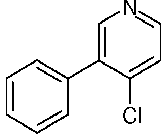 | 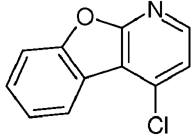 |
| 1207-69-8* | 19069-63-7* | 31874-94-9* |
| 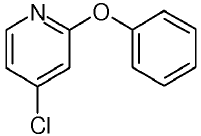 | 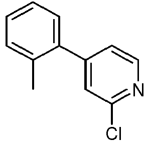 | 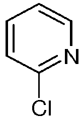 |
| 28373-64-0* | 883874-67-7* | 109-09-1* |
| 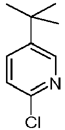 | 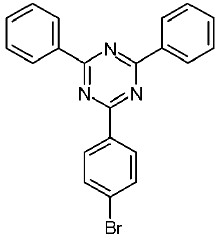 | 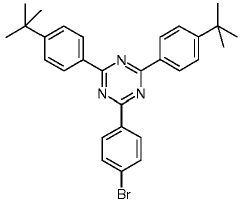 |
| 102236-19-1* | 23449-08-3 | 927898-18-8 |
| 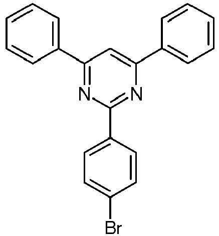 | 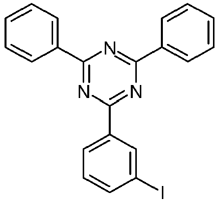 | |
| 457613-56-8 | 1476799-05-9 | |

| | | |
|---|---|---|
| * nicht erfindungsgemäß | | |

### Synthese des Liganden L4 aus einem Arylboronester und einem Arylhalogenid

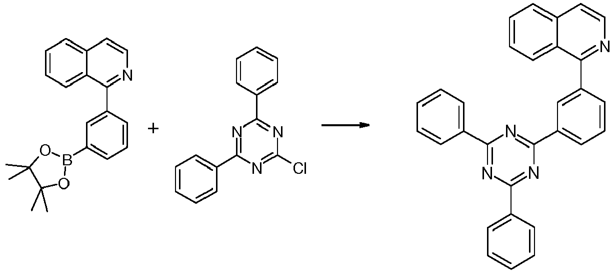

In einen 500 ml-Vierhalsrundkolben mit KPG-Rührer, Innenthermometer, Rückflusskühler und Schutzgasanschluss werden 50 g (151 mmol) 1-[2-(4,4,5,5-Tetra-methyl-[1,3,2]dioxaborolan-2-yl)-phenyl]-isochinolin (S3), 21 g (78.4 mmol) 2-Chlor-4,6-diphenyl-[1,3,5]triazin (CAS 3842-55-5) und 32 g (151 mmol) Kaliumphosphat in entgastem Toluol (150 ml) und 1,4-Dioxan (75 ml) suspendiert. Dazu werden Tri-o-tolylphosphin (2,3 g, 7,6 mmol), Palladiumacetat (0,85 g, 3,8 mmol) und entgastes Wasser (75 ml) gegeben. Die Reaktionsmischung wird für 7 h auf 100 °C Innentemperatur erwärmt. Nach dem Abkühlen wird der ausgefallene Niederschlag abgesaugt, mit wenig Wasser und Toluol nachgewaschen und über Nacht im Vakuumtrockenschrank bei 60 °C getrocknet. Der Rückstand wird in etwa 400 ml Toluol gelöst und über Kieselgel filtriert, das Kieselgel mit Toluol nachgewaschen, die organischen Phasen vereinigt und vom Lösemittel befreit. Der Feststoff wird mehrfach aus Toluol umkristallisiert. Es werden 25,8 g (117,7 mmol, 78% Ausbeute) eines farblosen Feststoffes erhalten.

Analog dieser Synthesevorschrift können folgende Liganden hergestellt werden.

| **Bsp.** | **Synthon** | **Arylhalogenid [CAS-Nummer]** | **Ligand** | **Ausbeute** |
|---|---|---|---|---|
| L1 | S6 | 253158-13-3 | 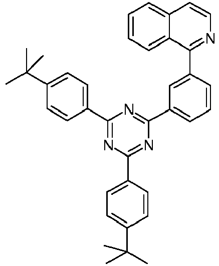 | 75% |
| L2* | S6 | 696-85-5 | 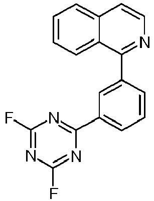 | 71% |
| L3* | S6 | 2972-65-8 | 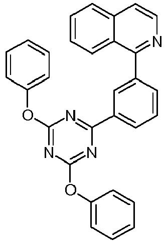 | 65% |
| L5* | S6 | 73084-03-4 | 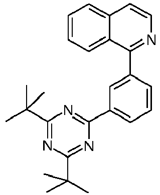 | 70% |
| L6* | S6 | 83820-01-3 | 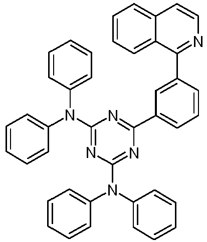 | 87% |
| L7 | S6 | 877615-05-9 | 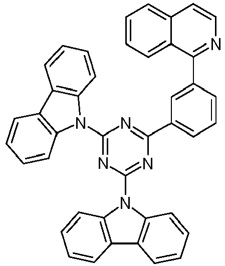 | 84% |
| L8* | S6 | 19138-11-5 | 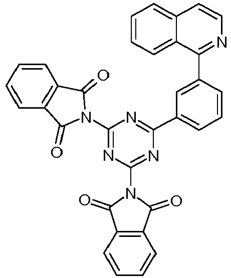 | 81% |
| L9* | S6 | 804-67-1 | 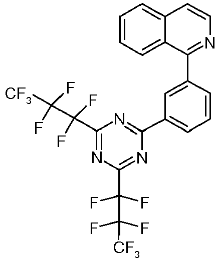 | 76% |
| L10 | S6 | 2915-16-4 | 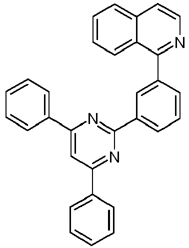 | 76% |
| L11* | S6 | 71162-19-1 | 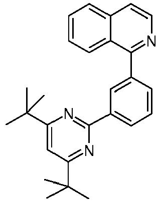 | 71% |
| L12 | S6 | 1421599-31-6 | 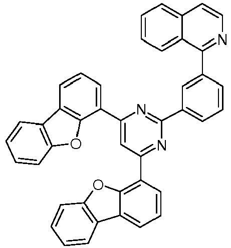 | 56% |
| L13* | S6 | 529874-83-7 | 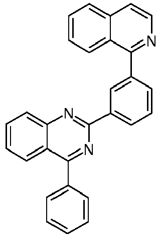 | 61% |
| L14* | S6 | 209409-84-7 | 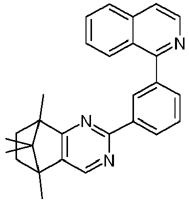 | 59% |
| L15* | S6 | 1092837-92-7 | 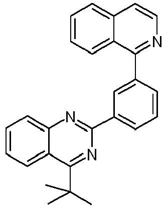 | 70% |
| L16* | S6 | 666854-39-3 | 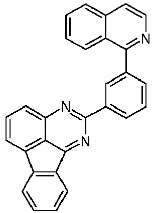 | 75% |
| L17* | S6 | 85929-94-8 | 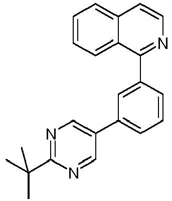 | 64% |
| L18* | S6 | 81269-96-7 | 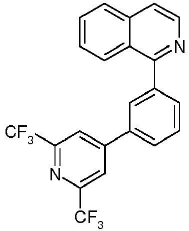 | 58% |
| L19* | S6 | 611-35-8 | 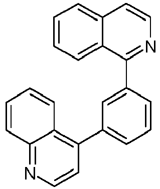 | 67% |
| L20* | S6 | 1207-69-8 | 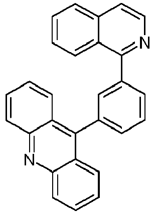 | 69% |
| L21* | S6 | 19069-63-7 | 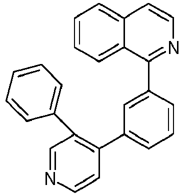 | 45% |
| L22* | S6 | 31874-94-9 | 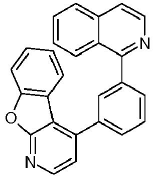 | 51% |
| L23* | S6 | 90732-01-7 | 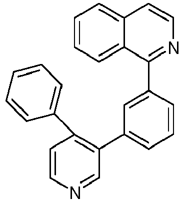 | 32% |
| L24* | S6 | 284040-67-1 | 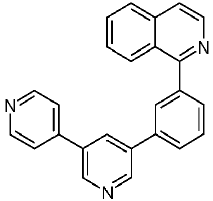 | 58% |
| L25* | S6 | 626-60-8 | 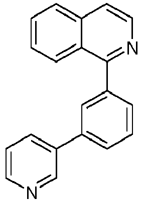 | 43% |
| L26 | S6 | S12 | 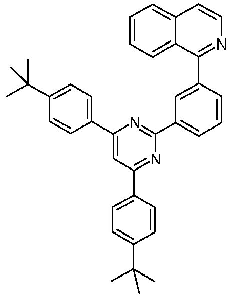 | 52% |
| L27 | S7 | 253158-13-3 | 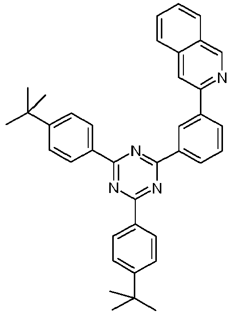 | 45% |
| L28* | S7 | 696-85-5 | 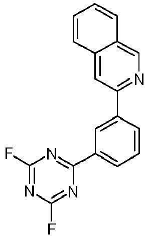 | 35% |
| L29* | S7 | 2972-65-8 | 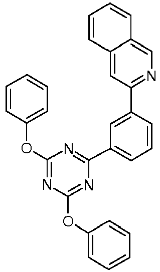 | 51% |
| L30* | S7 | 73084-03-4 | 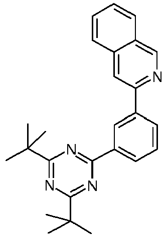 | 34% |
| L31* | S7 | 83820-01-3 | 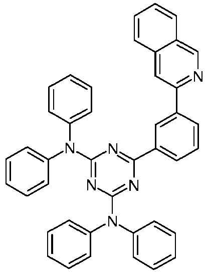 | 34% |
| L32 | S7 | 877615-05-9 | 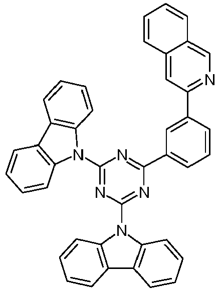 | 48% |
| L33* | S7 | 19138-11-5 | 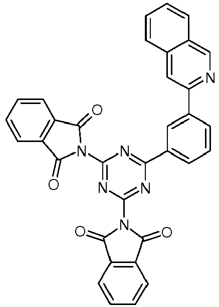 | 29% |
| L34* | S7 | 804-67-1 | 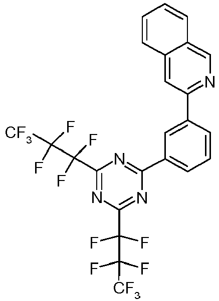 | 21% |
| L35 | S7 | 2915-16-4 | 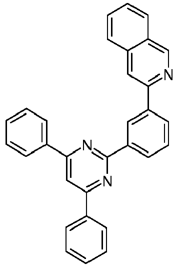 | 78% |
| L36* | S7 | 71162-19-1 | 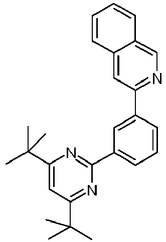 | 65% |
| L37 | S7 | 1421599-31-6 | 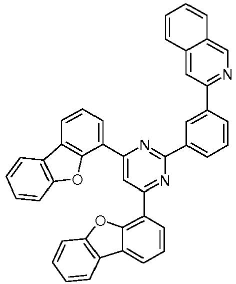 | 81% |
| L38* | S7 | 529874-83-7 | 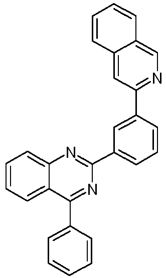 | 59% |
| L39* | S7 | 209409-84-7 | 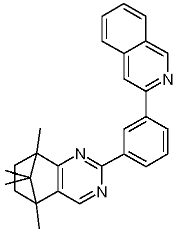 | 43% |
| L40* | S7 | 1092837-92-7 | 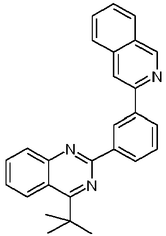 | 67% |
| L41* | S7 | 666854-39-3 | 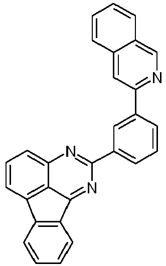 | 72% |
| L42* | S7 | 85929-94-8 | 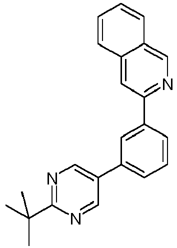 | 88% |
| L43* | S7 | 81269-96-7 | 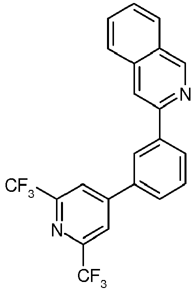 | 66% |
| L44* | S7 | 611-35-8 | 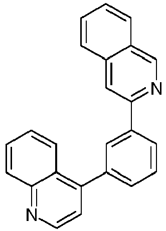 | 73% |
| L45* | S7 | 1207-69-8 | 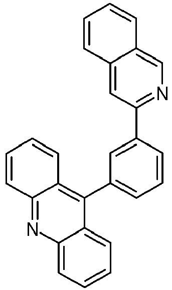 | 33% |
| L46* | S7 | 19069-63-7 | 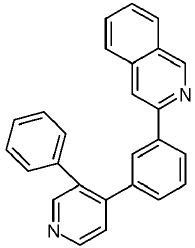 | 21% |
| L47* | S7 | 31874-94-9 | 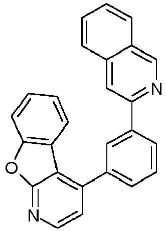 | 65% |
| L48* | S7 | 90732-01-7 | 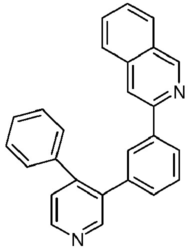 | 36% |
| L49* | S7 | 284040-67-1 | 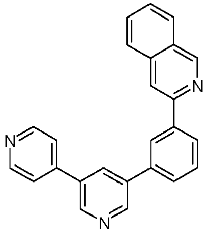 | 87% |
| L50* | S7 | 626-60-8 | 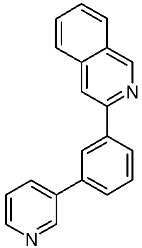 | 74% |
| L51 | S8 | 253158-13-3 | 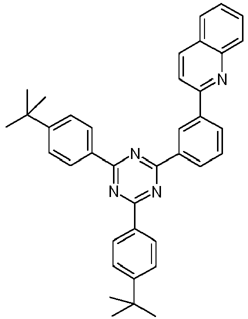 | 71% |
| L52* | S8 | 83820-01-3 | 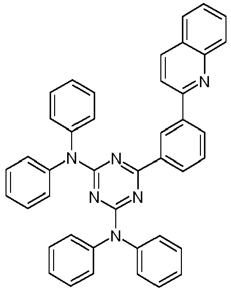 | 64% |
| L53 | S8 | 877615-05-9 | 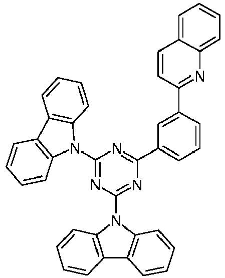 | 70% |
| L54 | S8 | 2915-16-4 | 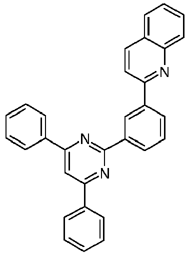 | 65% |
| L55 | S8 | 1421599-31-6 | 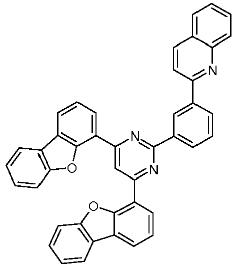 | 54% |
| L56* | S8 | 209409-84-7 | 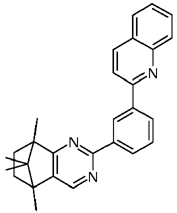 | 73% |
| L57 | S9 | 253158-13-3 | 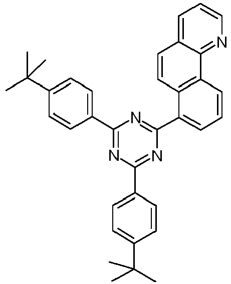 | 62% |
| L58* | S9 | 2972-65-8 | 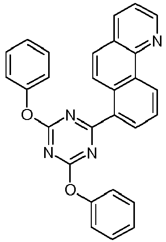 | 76% |
| L59* | S9 | 83820-01-3 | 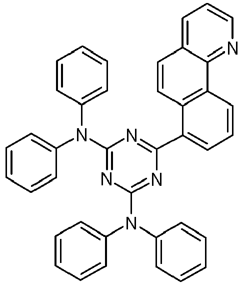 | 59% |
| L60 | S9 | 877615-05-9 | 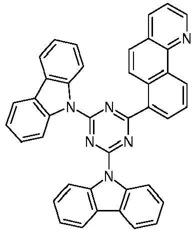 | 48% |
| L61* | S9 | 19138-11-5 | 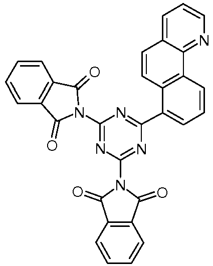 | 36% |
| L62* | S9 | 804-67-1 | 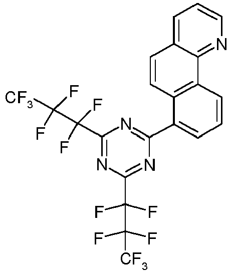 | 19% |
| L63 | S9 | 2915-16-4 | 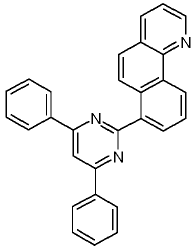 | 58% |
| L64* | S9 | 209409-84-7 | 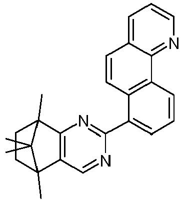 | 52% |
| L65* | S9 | 19069-63-7 | 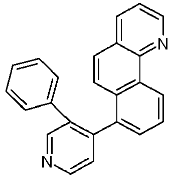 | 31% |
| L66* | S9 | 31874-94-9 | 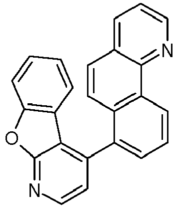 | 45% |
| L67 | S10 | 253158-13-3 | 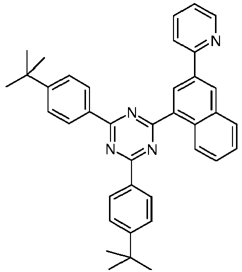 | 61% |
| L68 | S10 | 877615-05-9 | 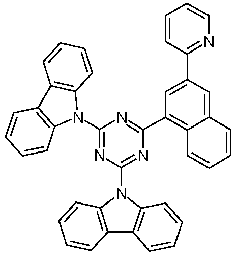 | 72% |
| L69 | S10 | 2915-16-4 | 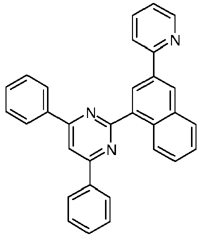 | 78% |
| L70* | S10 | 71162-19-1 | 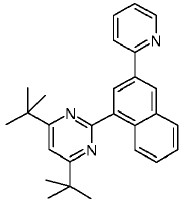 | 81% |
| L71* | S10 | 209409-84-7 | 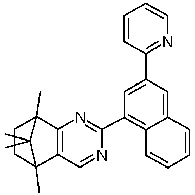 | 75% |
| L72 | S6 | 23449-08-3 | 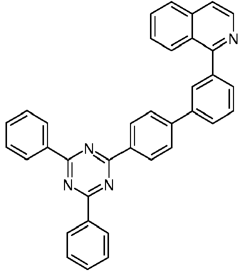 | 65% |
| L73 | S6 | 927898-18-8 | 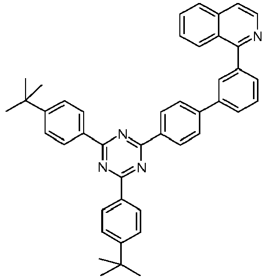 | 58& |
| L74 | S6 | 457613-56-8 | 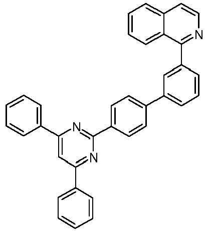 | 71% |
| L75 | S6 | S11 | 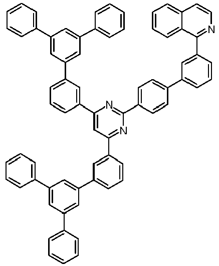 | 74% |
| L76 | S7 | 23449-08-3 | 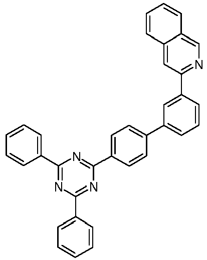 | 81% |
| L77 | S7 | 927898-18-8 | 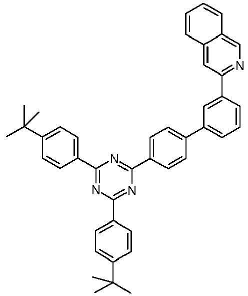 | 78% |
| L78 | S7 | 457613-56-8 | 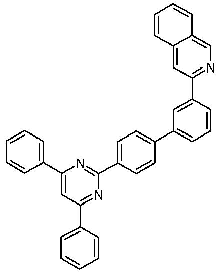 | 80% |
| L79 | S8 | 23449-08-3 | 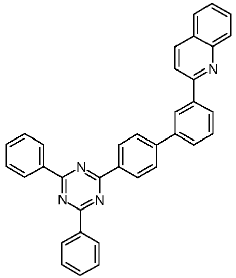 | 69% |
| L80 | S8 | 927898-18-8 | 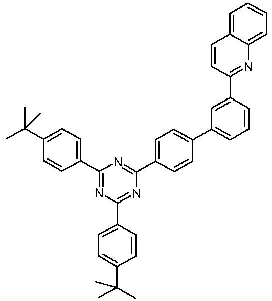 | 73% |
| L81 | S8 | 457613-56-8 | 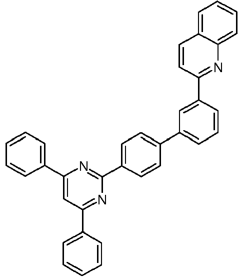 | 78% |
| L82 | S9 | 23449-08-3 | 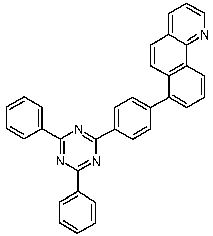 | 72% |
| L83 | S9 | 927898-18-8 | 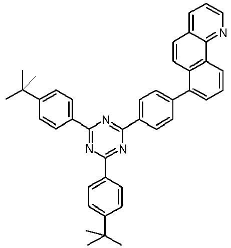 | 61% |
| L84 | S9 | 457613-56-8 | 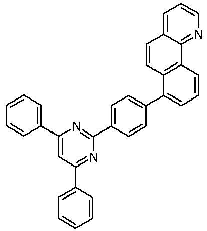 | 67% |
| L85 | S10 | 23449-08-3 | 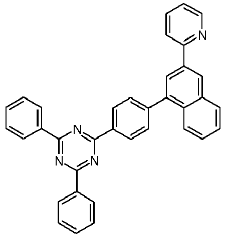 | 63% |
| L86 | S10 | 927898-18-8 | 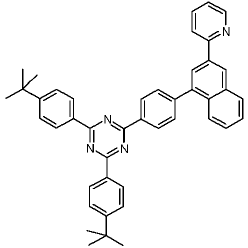 | 58% |
| L87 | S10 | 457613-56-8 | 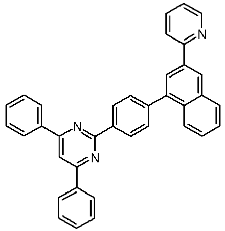 | 57% |
| L-V5 | S6 | 1476799-05-9 | 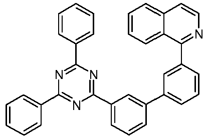 | 59% |

| | | | | |
|---|---|---|---|---|
| * nicht erfindungsgemäß | | | | |

### Synthese der Metallkomplexe

### 1) Homoleptische tris-faciale Iridium-Komplexe vom Phenyl-Pyridin-, Phenyl-Imidazol- bzw. Phenyl-Benzimidazol-Typ

### Variante A: Tris-acetylacetonato-iridium(III) als Iridium-Edukt

Ein Gemisch aus 10 mmol Tris-acetylacetonato-iridium(III) [15635-87-7] und 40-60 mmol (bevorzugt 40 mmol) des Liganden L, gegebenenfalls 1-10 g - typischerweise 3 g - eines inerten hochsiedenden Zusatzes als Schmelzhilfe bzw. Lösungsmittel, z. B. Hexadecan, m-Terphenyl, Triphenylen, Bisphenylether, 3-Phenoxy-toluol, 1,2-, 1,3-, 1,4-Bis-phenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird.

Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5% wird der Heißextraktionsschritt wiederholt, wobei ab der 2. Extraktion das Alox-Bett weggelassen wird. Ist eine Reinheit von 99.5 - 99.9% erreicht, wird der Metallkomplex getempert oder chromatographiert. Das Tempern erfolgt im Hochvakuum (p ca. 10⁻⁶ mbar) im Temperaturbereich von ca. 200 - 300 °C. Gut in organischen Lösungsmitteln lös liche Komplexe können alternativ auch an Kieselgel chromatograpiert werden.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) [15635-87-7] 10 mmol Tris-(2,2,6,6-tetramethyl-3,5-heptandionato)iridium [99581-86-9] eingesetzt werden. Die Verwendung dieses Edukts ist vorteilhaft, da die Reinheit der erhaltenen Rohprodukte häufig besser ist als bei Variante A. Außerdem ist der Druckaufbau in der Ampulle häufig nicht so ausgeprägt.

### Variante C: Natrium[cis,trans-dichloro-bis(acetylacetonato)]iridat(III) als Iridium-Edukt

Ein Gemisch aus 10 mmol Natrium[cis,trans-di-chloro-bis(acetyl-acetonato)]iridat(III) [876296-21-8] und 60 mmol das Liganden in 50 ml Ethylen-, Propylen- oder Diethylenglykol wird unter einem leichten Argonstrom für die angegebene Zeit unter schwachem Rückfluss erhitzt. Nach Erkalten auf 60 °C verdünnt man unter Rühren mit ei nem Gemisch aus 50 ml Ethanol und 50 ml 2 N Salzsäure, rührt 1 h nach, saugt vom ausgefallenen Feststoff ab, wäscht diesen dreimal mit je 30 ml Ethanol und trocknet dann im Vakuum. Reinigung durch Heißextraktion oder Chromatographie und fraktionierte Sublimation, wie unter A beschrieben.

| **Bsp.** | **Ligand L** | **Ir-Komplex Diastereomer** | **Variante Reaktionsmedium Schmelzhilfe Reaktionstemp. Reaktionszeit Suspensionsmittel Extraktionsmittel** | **Ausbeute** |
|---|---|---|---|---|
| Ir(L1)₃ | L1 | 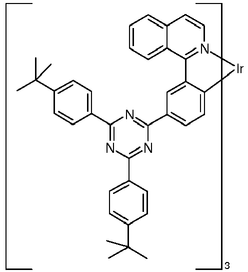 | A | 22% |
| | | | --- | |
| | | | --- | |
| | | | 285 °C 24 h EtOH Toluol | |
| Ir(L2)₃* | L2 | 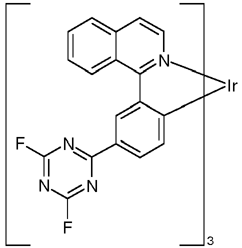 | A | 21% |
| | | | --- | |
| | | | --- | |
| | | | 265 °C 24 h MeOH Toluol | |
| Ir(L3)₃ | L3 | 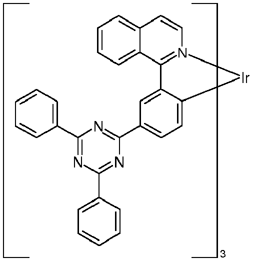 | A | 18% |
| | | | --- | |
| | | | --- | |
| | | | 285 °C 24 h EtOH o-Xylol | |
| Ir(L4)₃* | L4 | 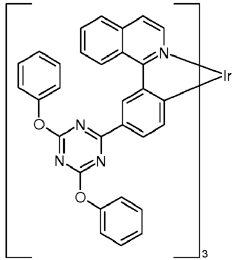 | A | 18% |
| | | | --- | |
| | | | --- | |
| | | | 275 °C 24 h EtOH Toluol | |
| Ir(L5)₃* | L5 | 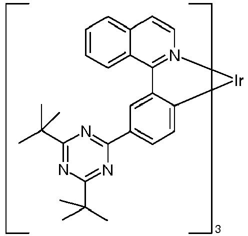 | wie Ir(L4)₃ | 24% |
| Ir(L6)₃* | L6 | 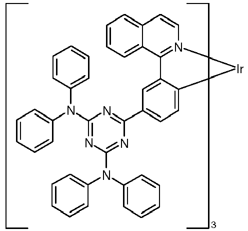 | B | 16% |
| | | | --- | |
| | | | --- | |
| | | | 285 °C 36 h Ethylacetat o-Xylol | |
| Ir(L7)₃ | L7 | 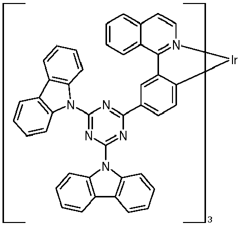 | A | 17% |
| | | | --- | |
| | | | 1-Naphthol 280 °C 24 h Ethylacetat Toluol | |
| Ir(L8)₃* | L8 | 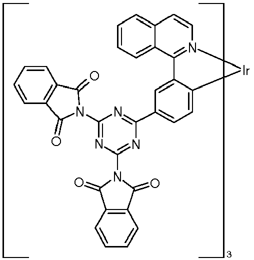 | A | 15% |
| | | | --- | |
| | | | 1-Naphthol 280 °C 24 h Ethanol o-Xylol | |
| Ir(L9)₃* | L9 | 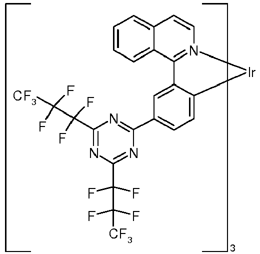 | A | 12% |
| | | | --- | |
| | | | 1-Naphthol 280 °C 24 h Ethylacetat Toluol | |
| Ir(L10)₃ | L10 | 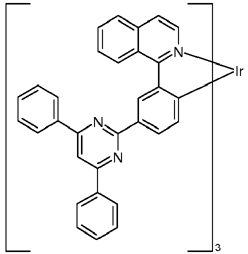 | A | 16% |
| | | | --- | |
| | | | --- | |
| | | | 275 °C 24 h EtOH o-Xylol | |
| Ir(L11)₃* | L11 | 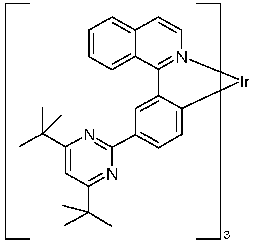 | A | 22% |
| | | | --- | |
| | | | --- | |
| | | | 275 °C 24 h EtOH Toluol | |
| Ir(L12)₃ | L12 | 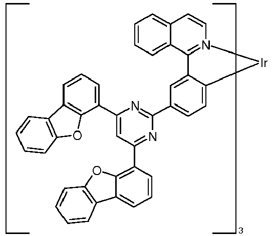 | A | 20% |
| | | | --- | |
| | | | Hydrochinon 270 °C 24 h Ethylacetat Toluol | |
| Ir(L13)₃* | L13 | 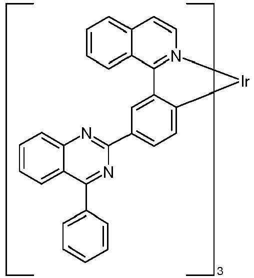 | A | 16% |
| | | | --- | |
| | | | --- | |
| | | | 280 °C 24 h Ethylacetat Xylol | |
| Ir(L14)₃* | L14 | 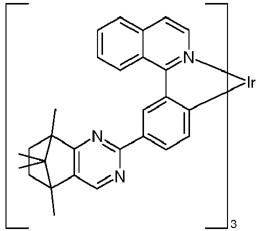 | A | 24% |
| | | | --- | |
| | | | --- | |
| | | | 270 °C 24 h Ethylacetat Toluol | |
| Ir(L15)₃* | L15 | 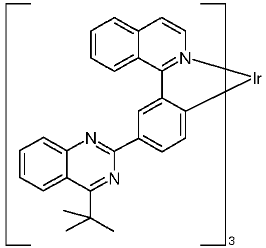 | A | 22% |
| | | | --- | |
| | | | --- | |
| | | | 280 °C 24 h Ethanol Toluol | |
| Ir(L16)₃* | L16 | 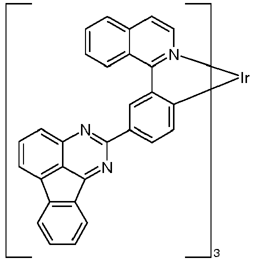 | A | 16% |
| | | | --- | |
| | | | 1-Naphthol 280 °C 24 h Ethylacetat Chlorbenzol | |
| Ir(L17)₃* | L17 | 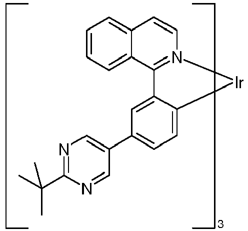 | A | 27% |
| | | | --- | |
| | | | 280 °C 24 h Ethylacetat Toluol | |
| Ir(L18)₃* | L18 | 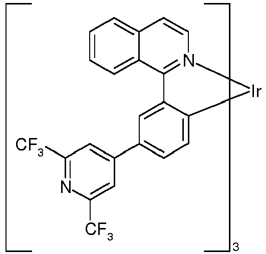 | A | 24% |
| | | | --- | |
| | | | Hydrochinon 270 °C 24 h Ethylacetat Toluol | |
| Ir(L19)₃* | L19 | 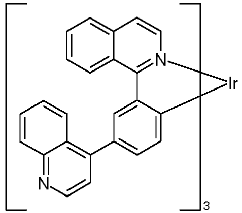 | A | 19% |
| | | | --- | |
| | | | Hydrochinon 270 °C 24 h Ethylacetat Toluol | |
| Ir(L20)₃* | L20 | 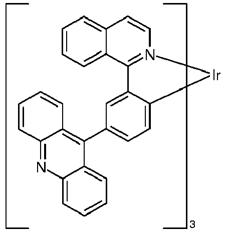 | B | 20% |
| | | | --- | |
| | | | --- | |
| | | | 300 °C 24 h Ethylacetat 1,2-Dichlorbenzol | |
| Ir(L21 )₃* | L21 | 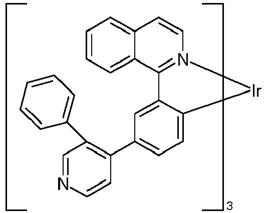 | A | 20% |
| | | | --- | |
| | | | --- | |
| | | | 285 °C 36 h Ethylacetat o-Xylol | |
| Ir(L22)₃* | L22 | 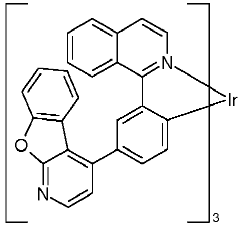 | A | 26% |
| | | | --- | |
| | | | Hydrochinon 280 °C 24 h Ethylacetat Toluol | |
| Ir(L23)₃* | L23 | 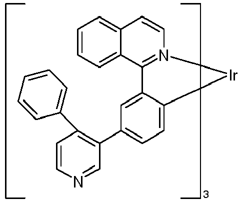 | C | 23% |
| | | | --- | |
| | | | --- | |
| | | | 285 °C 24 h Ethylacetat o-Xylol | |
| Ir(L24)₃* | L24 | 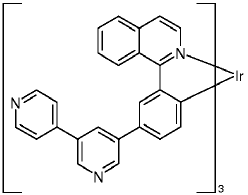 | C | 12% |
| | | | --- | |
| | | | --- | |
| | | | 285 °C 24 h Ethylacetat o-Xylol | |
| Ir(L25)₃* | L25 | 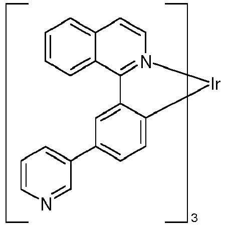 | wie Ir(L25)₃ | 14% |
| Ir(L26)₃ | L26 | 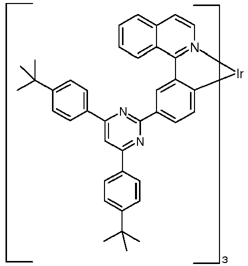 | A | 34% |
| | | | --- | |
| | | | --- | |
| | | | 275 °C 48 h Ethylacetat Toluol | |
| Ir(L27)₃ | L27 | 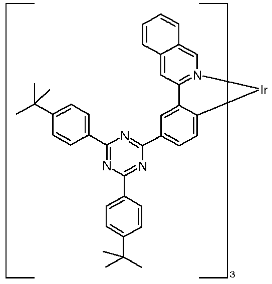 | A | 25% |
| | | | --- | |
| | | | --- | |
| | | | 285 °C 24 h Ethylacetat Toluol | |
| Ir(L28)₃* | L28 | 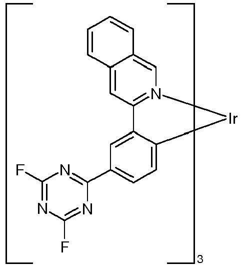 | C | 22% |
| | | | --- | |
| | | | --- | |
| | | | 275 °C 24 h Ethanol Mesitylen | |
| Ir(L29)₃* | L29 | 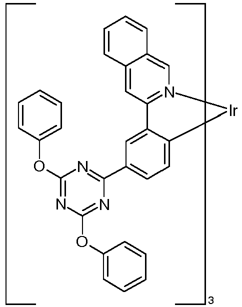 | A | 20% |
| | | | --- | |
| | | | Hydrochinon 275 °C 24 h Ethanol Toluol | |
| Ir(L30)₃* | L30 | 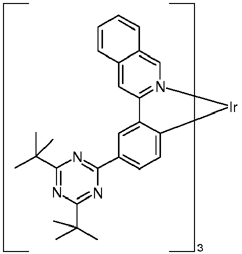 | wie Ir(L28)₃ | 24% |
| Ir(L31 )₃* | L31 | 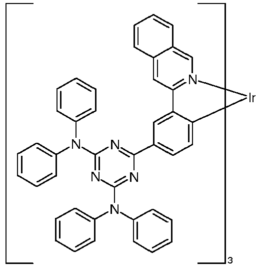 | C | 18% |
| | | | --- | |
| | | | --- | |
| | | | 285 °C 36 h Ethylacetat o-Xylol | |
| Ir(L32)₃ | L32 | 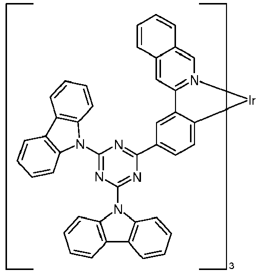 | A | 21% |
| | | | --- | |
| | | | Hydrochinon 280 °C 24 h Ethylacetat Chlorbenzol | |
| Ir(L33)₃* | L33 | 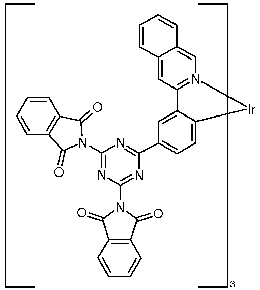 | B | 14% |
| | | | --- | |
| | | | --- | |
| | | | 290 °C 24 h Ethylacetat Mesitylen | |
| Ir(L34)₃* | L34 | 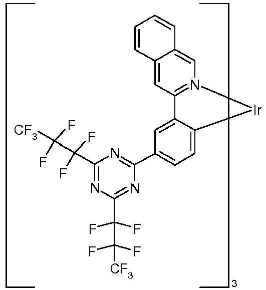 | A | 14% |
| | | | --- | |
| | | | Hydrochinon 280 °C 36 h Ethylacetat Chlorbenzol | |
| Ir(L35)₃ | L35 | 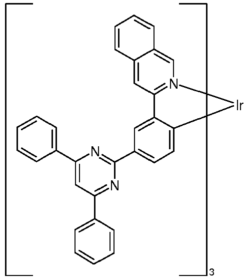 | A | 21% |
| | | | --- | |
| | | | --- | |
| | | | 290 °C 24 h Ethylacetat Toluol | |
| Ir(L36)₃* | L36 | 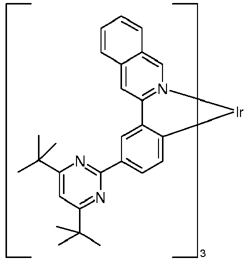 | A | 18% |
| | | | --- | |
| | | | --- | |
| | | | 280 °C 24 h Ethylacetat o-Xylol | |
| Ir(L37)₃ | L37 | 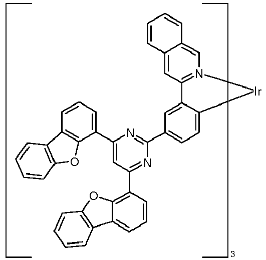 | A | 21% |
| | | | --- | |
| | | | 1-Naphthol 280 °C 24 h Ethylacetat Toluol | |
| Ir(L38)₃* | L38 | 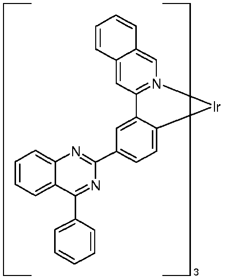 | A | 17% |
| | | | --- | |
| | | | Hydrochinon 270 °C 24 h Ethylacetat o-Xylol | |
| Ir(L39)₃* | L39 | 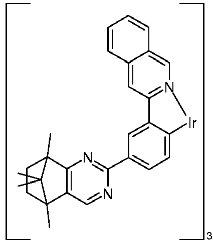 | B | 18% |
| | | | --- | |
| | | | --- | |
| | | | 290 °C 24 h Ethanol Toluol | |
| Ir(L40)₃* | L40 | 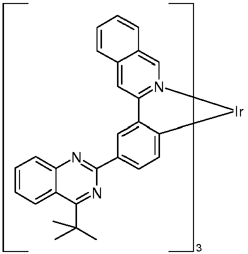 | C | 15% |
| | | | --- | |
| | | | --- | |
| | | | 280 °C 24 h Ethylacetat o-Xylol | |
| Ir(L41 )₃* | L41 | 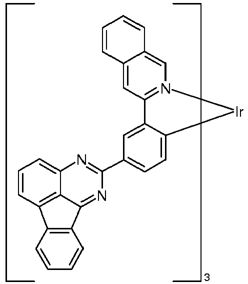 | A | 16% |
| | | | --- | |
| | | | 1-Naphthol 280 °C 24 h Ethylacetat Mesitylen | |
| Ir(L42)₃* | L42 | 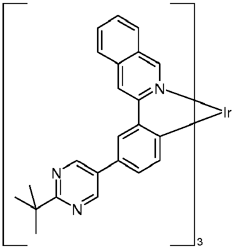 | A | 16% |
| | | | --- | |
| | | | --- | |
| | | | 270 °C 24 h Ethylacetat Toluol | |
| Ir(L43)₃* | L43 | 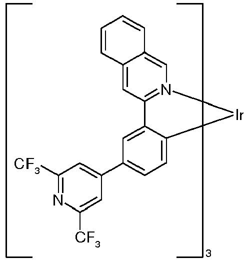 | C | 16% |
| | | | --- | |
| | | | --- | |
| | | | 280 °C 24 h Ethylacetat Mesitylen | |
| Ir(L44)₃* | L44 | 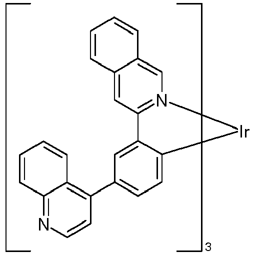 | A | 19% |
| | | | --- | |
| | | | Hydrochinon 270 °C 24 h Ethylacetat o-Xylol | |
| Ir(L45)₃* | L45 | 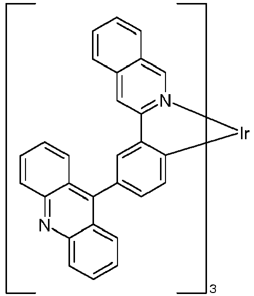 | B | 15% |
| | | | --- | |
| | | | --- | |
| | | | 300 °C 36 h Ethylacetat o-Dichlorbenzol | |
| Ir(L46)₃* | L46 | 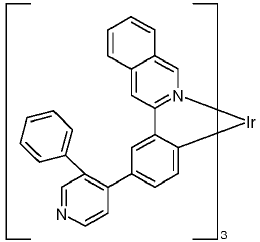 | wie Ir(L25)₃ | 18% |
| Ir(L47)₃* | L47 | 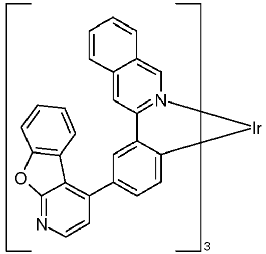 | B | 19% |
| | | | --- | |
| | | | --- | |
| | | | 290 °C 24 h Ethanol Toluol | |
| Ir(L48)₃* | L48 | 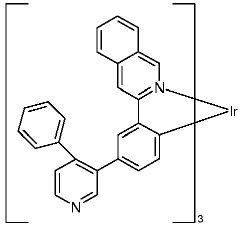 | wie Ir(L25)₃ | 19% |
| Ir(L49)₃* | L49 | 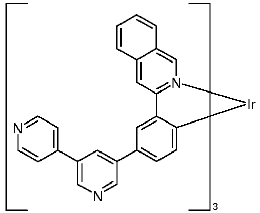 | wie Ir(L25)₃ | 14% |
| Ir(L50)₃* | L50 | 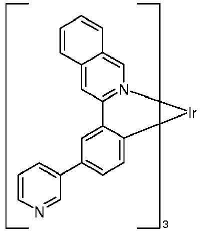 | wie Ir(L25)₃ | 16% |
| Ir(L51)₃ | L51 | 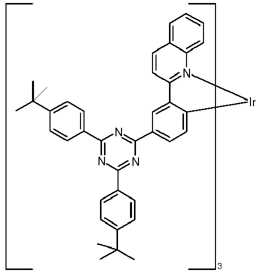 | B | 8% |
| | | | --- | |
| | | | --- | |
| | | | 290 °C 36 h Ethanol Toluol | |
| Ir(L52)₃* | L52 | 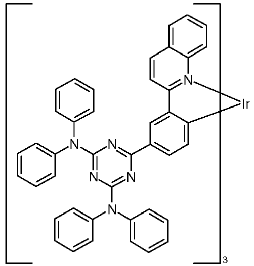 | wie Ir(L50)₃ | 10% |
| Ir(L53)₃ | L53 | 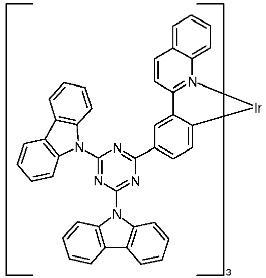 | wie Ir(L50)₃ | 5% |
| Ir(L54)₃ | L54 | 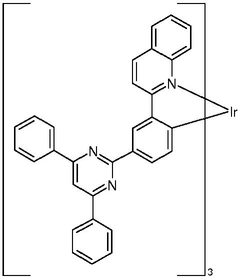 | wie Ir(L50)₃ | 7% |
| Ir(L55)₃ | L55 | 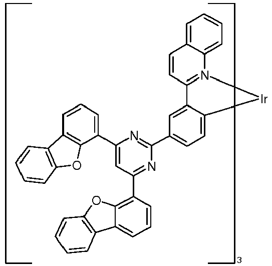 | A | 9% |
| | | | --- | |
| | | | Hydrochinon 280 °C 24 h Ethylacetat o-Xylol | |
| Ir(L56)₃* | L56 | 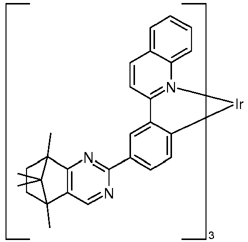 | wie Ir(L50)₃ | 8% |
| Ir(L57)₃ | L57 | 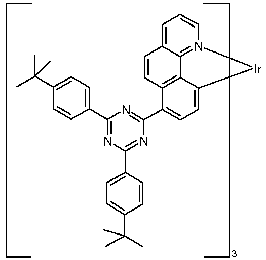 | A | 18% |
| | | | --- | |
| | | | --- | |
| | | | 280 °C 24 h Ethylacetat Chlorbenzol | |
| Ir(L58)₃* | L58 | 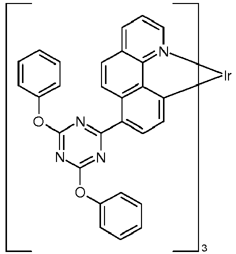 | A | 16% |
| | | | --- | |
| | | | --- | |
| | | | 280 °C 24 h Ethylacetat o-Xylol | |
| Ir(L59)₃* | L59 | 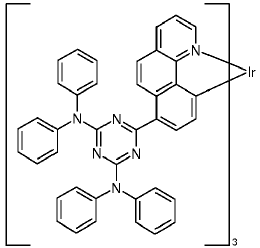 | wie Ir(L57)₃ | 12% |
| Ir(L60)₃ | L60 | 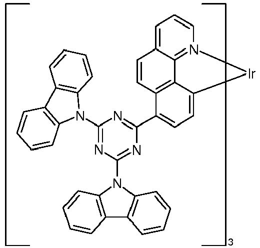 | wie Ir(L57)₃ | 9% |
| Ir(L61 )₃* | L61 | 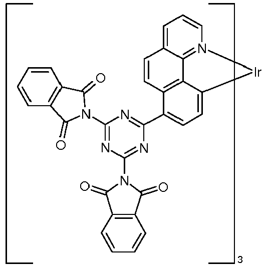 | A | 8% |
| | | | --- | |
| | | | Hydrochinon 280 °C 24 h Ethylacetat o-Dichlorbenzol | |
| Ir(L62)₃* | L62 | 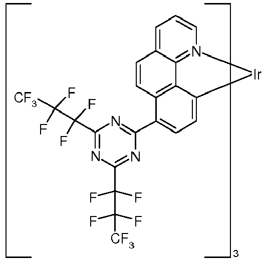 | wie Ir(L57)₃ | 11% |
| Ir(L63)₃ | L63 | 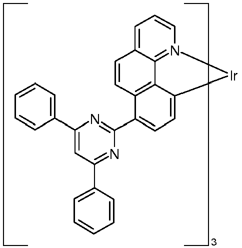 | wie Ir(L57)₃ | 8% |
| Ir(L64)₃* | L64 | 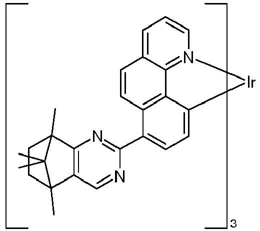 | wie Ir(L56)₃ | 12% |
| Ir(L65)₃* | L65 | 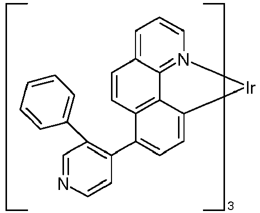 | C | 8% |
| | | | --- | |
| | | | --- | |
| | | | 280 °C 24 h Ethylacetat o-Xylol | |
| Ir(L66)3* | L66 | 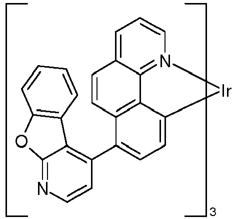 | A | 11% |
| | | | --- | |
| | | | 1-Naphthol 270 °C 36 h Ethylacetat Mesitylen | |
| Ir(L67)₃ | L67 | 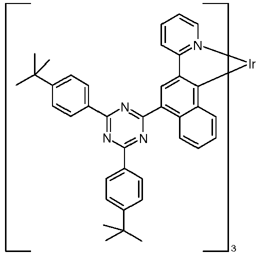 | B | 5% |
| | | | --- | |
| | | | --- | |
| | | | 290 °C 24 h Ethylacetat o-Xylol | |
| Ir(L68)₃ | L68 | 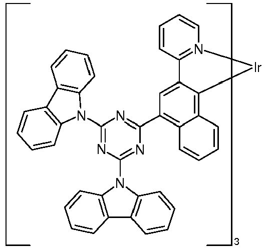 | A | 3% |
| | | | --- | |
| | | | Hydrochinon 280 °C 24 h Ethylacetat Chlorbenzol | |
| Ir(L69)₃ | L69 | 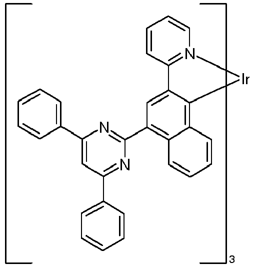 | C | 6% |
| | | | --- | |
| | | | --- | |
| | | | 280 °C 24 h Ethylacetat o-Xylol | |
| Ir(L70)₃* | L70 | 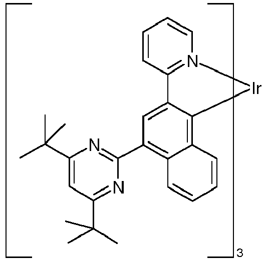 | C | 6% |
| | | | --- | |
| | | | --- | |
| | | | 270 °C 24 h Ethylacetat o-Dichlorbenzol | |
| Ir(L71 )₃* | L71 | 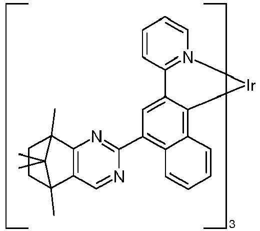 | A | 5% |
| | | | --- | |
| | | | --- | |
| | | | 270 °C 24 h Ethylacetat Mesitylen | |
| Ir(L72)₃ | L72 | 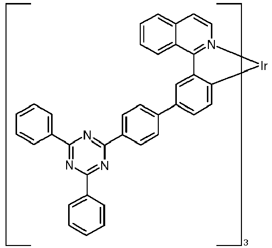 | A | 15% |
| | | | --- | |
| | | | --- | |
| | | | 260 °C 48 h Ethylacetat Toluol | |
| Ir(L73)₃ | L73 | 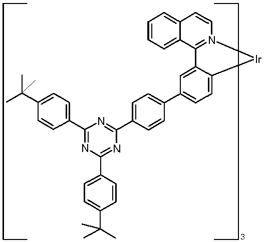 | A | 12% |
| | | | --- | |
| | | | --- | |
| | | | 260 °C 48 h Propanol Toluol | |
| Ir(L74)₃ | L74 | 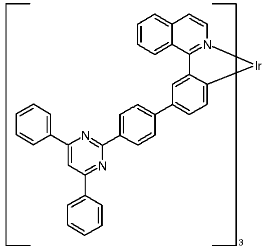 | A | 14% |
| | | | --- | |
| | | | --- | |
| | | | 250 °C 48 h Ethanol Toluol | |
| Ir(L75)₃ | L75 | 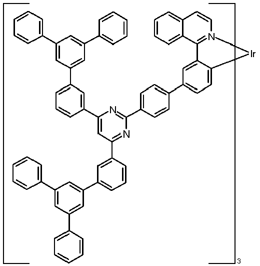 | A | 18% |
| | | | --- | |
| | | | --- | |
| | | | 250 °C 48 h Ethylacetat Toluol | |
| Ir(L76)₃ | L76 | 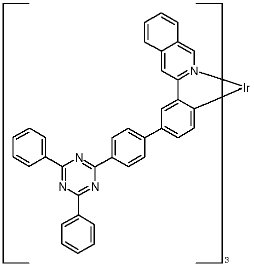 | A | 10% |
| | | | --- | |
| | | | --- | |
| | | | 260 °C 48 h Ethanol o-Xylol | |
| Ir(L77)₃ | L77 | 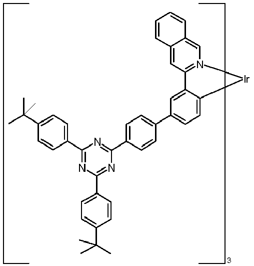 | A | 14% |
| | | | --- | |
| | | | --- | |
| | | | 255 °C 48 h Methanol Toluol | |
| Ir(L78)₃ | L78 | 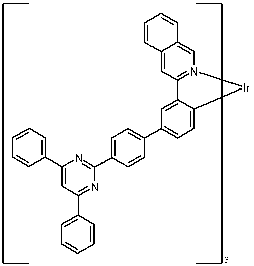 | A | 7% |
| | | | --- | |
| | | | --- | |
| | | | 255 °C 48 h Ethanol p-Xylol | |
| Ir(L79)₃ | L79 | 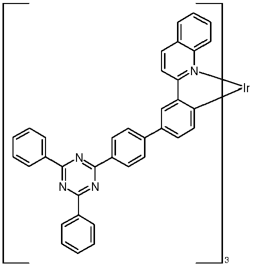 | A | 2% |
| | | | --- | |
| | | | --- | |
| | | | 260 °C 48 h Propanol o-Xylol | |
| Ir(L80)₃ | L80 | 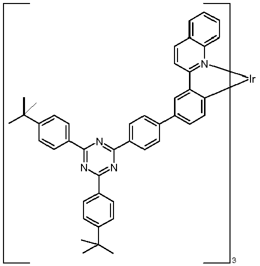 | A | 5% |
| | | | --- | |
| | | | --- | |
| | | | 260 °C 48 h Methanol Toluol | |
| Ir(L81)₃ | L81 | 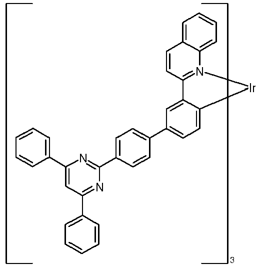 | A | 6% |
| | | | --- | |
| | | | --- | |
| | | | 260 °C 48 h Methanol Toluol | |
| Ir(L82)₃ | L82 | 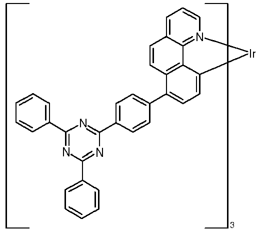 | A | 19% |
| | | | --- | |
| | | | --- | |
| | | | 260 °C 48 h Butanol Chlorbenzol | |
| Ir(L83)₃ | L83 | 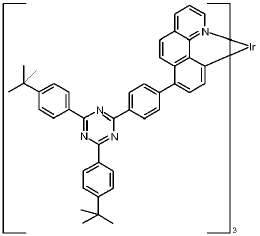 | A | 21% |
| | | | --- | |
| | | | --- | |
| | | | 260 °C 48 h Methanol Toluol | |
| Ir(L84)₃ | L84 | 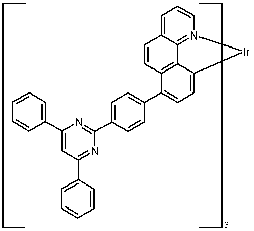 | A | 23% |
| | | | --- | |
| | | | --- | |
| | | | 260 °C 48 h Ethylacetat Toluol | |
| Ir(L85)₃ | L85 | 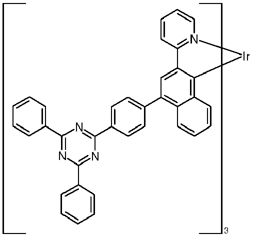 | A | 8% |
| | | | --- | |
| | | | --- | |
| | | | 260 °C 48 h Ethanol Toluol | |
| Ir(L86)₃ | L86 | 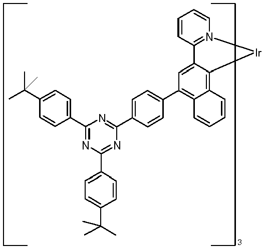 | A | 6% |
| | | | --- | |
| | | | --- | |
| | | | 260 °C 48 h Methanol Toluol | |
| Ir(L87)₃ | L87 | 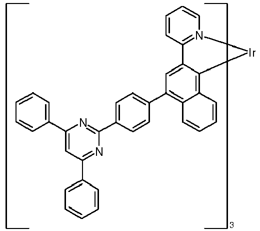 | A | 7% |
| | | | --- | |
| | | | --- | |
| | | | 260 °C 48 h Ethylacetat Toluol | |
| V5 | L-V5 | 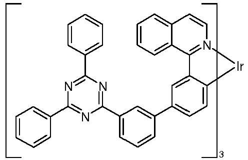 | A | 17% |
| | | | --- | |
| | | | --- | |
| | | | 260 °C 48 h Methanol o-Xylol | |

| | | | | |
|---|---|---|---|---|
| * nicht erfindungsgemäß | | | | |

### 2) Heteroleptische Iridium-Komplexe:

### Variante A:

### Schritt 1:

Ein Gemisch aus 10 mmol Natrium-bis-acetylacetonato-dichloro-iridat(III) [770720-50-8] und 24 mmol des Liganden L und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Nach Erkalten - ACHTUNG: die Ampullen stehen meist unter Druck! - wird die Ampulle geöffnet, der Sinterkuchen wird mit 100 g Glaskugeln (3 mm Durchmesser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind DCM, Aceton, Ethylacetat, Toluol, etc.) 3 h gerührt und dabei mechanisch aufgeschlossen. Man dekantiert die feine Suspension von den Glaskugeln ab, saugt den Feststoff (Ir(L)₂Cl]₂, das noch ca. 2 eq NaCl enthält, nachfolgend das rohe Chloro-Dimer genannt) ab und trocknet diesen im Vakuum.

### Schritt 2:

Das so erhaltene rohe Chloro-Dimer der Formel [Ir(L)₂Cl]₂ wird in einem Gemisch aus 75 ml 2-Ethoxyethanol und 25 ml Wasser suspendiert, mit 13 mmol des Co-Liganden CL bzw. der Co-Liganden-Verbindung CL und 15 mmol Natriumcarbonat versetzt. Nach 20 h unter Rückfluss gibt man weitere 75 ml Wasser tropfenweise zu, saugt nach Erkalten vom Feststoff ab, wäscht diesen dreimal mit je 50 ml Wasser und dreimal mit je 50 ml Methanol und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit dem angegebenen Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, Tetrahydrofuran, Dichlormethan, 1,2-Dichlorethan, 1,1,2,2-Tetrachlorethan, Chloroform, Tetrachlorkohlenstoff) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metall-Komplexes mittels NMR und / oder HPLC bestimmt. Liegt die Reinheit unter 99.5 % wird der Heißextraktionsschritt wiederholt, ist eine Reinheit von 99.5 - 99.9 % erreicht, wird der Metallkomplex getempert oder sublimiert. Neben dem Heißextraktionsverfahren zur Reinigung kann die Reinigung auch chromatographisch an Kieselgel oder Alox erfolgen. Das Tempern erfolgt im Hochvakuum (p ca. 10⁻⁶ mbar) im Temperaturbereich von ca. 200 - 300 °C. Die Sublimation erfolgt im Ho chvakuum (p ca. 10⁻⁶ mbar) im Temperaturbereich von ca. 300 - 400 °C, wo bei die Sublimation bevorzugt in Form einer fraktionierten Sublimation durchgeführt wird.

| **Bsp.** | **Ligand L** | **Co-Ligand CL** | **Ir-Komplex Schritt 1: Reaktionstemp.** / **Reaktionszeit** / **Suspensionsmittel Schritt 2: Extraktionsmittel** | **Ausbeute** |
|---|---|---|---|---|
| Ir(L1)₂(CL1) | L1 | 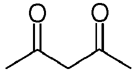 | 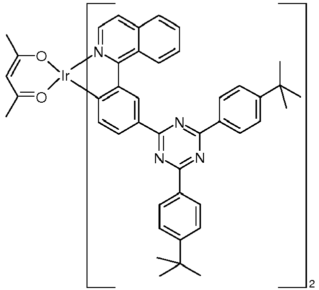 | 28% |
| | | 123-54-6 CL1 | 260 °C / 60 h / Aceton Toluol | |
| Ir(L5)₂(CL1)* | L5 | CL1 | 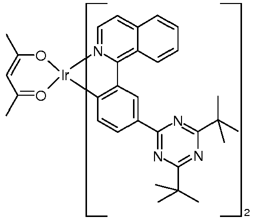 | 22% |
| | | | 260 °C / 48 h / Ethylacetat o-Xylol | |
| Ir(L6)₂(CL1)* | L6 | CL1 | 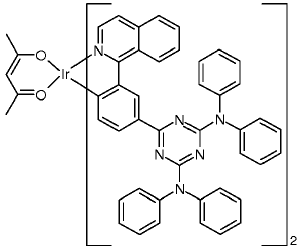 | 31% |
| | | | 260 °C / 60 h / Ethylacetat Toluol | |
| Ir(L10)₂(CL1) | L10 | CL1 | 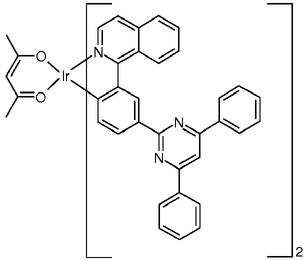 | 26% |
| | | | 260 °C / 60 h / Aceton Toluol | |
| Ir(L32)₂(CL1) | L32 | CL1 | 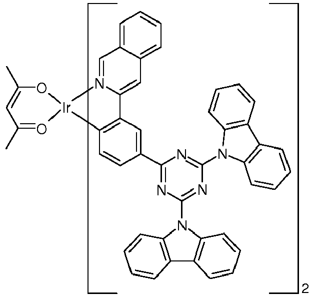 | 28% |
| | | | 270 °C / 60 h / Ethylacetat Toluol | |
| Ir(L37)₂(CL1) | L37 | CL1 | 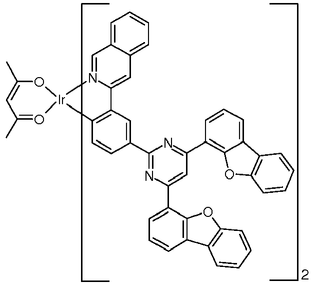 | 24% |
| | | | 270 °C / 60 h / Ethylacetat Toluol | |
| Ir(L56)₂(CL1)* | L56 | CL1 | 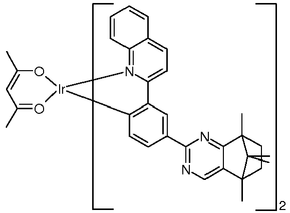 | 22% |
| | | | 280 °C / 60 h / Ethylacetat Xylol | |
| Ir(L51)₂(CL1) | L51 | CL2 | 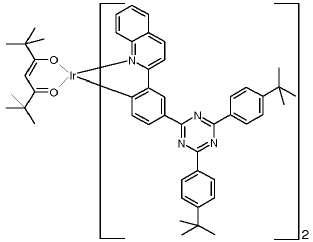 | 27% |
| | | | 290 °C / 60 h / Ethylacetat Xylol | |
| Ir(L52)₂(CL2)* | L52 | CL2 | 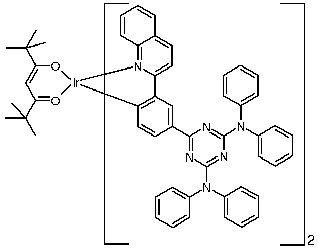 | 23% % |
| | | | 290 °C / 72 h / Aceton Xylol | |
| Ir(L54)₂(CL2) | L54 | CL2 | 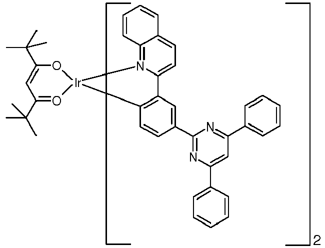 | 26% |
| | | | 290 °C / 60 h / Ethylacetat THF | |
| Ir(L55)₂(CL2) | L55 | CL2 | 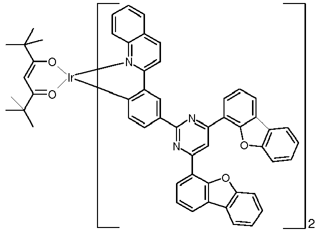 | 30% |
| | | | 300 °C / 72 h / Ethylacetat Toluol | |
| Ir(L67)₂(CL2) | L67 | CL2 | 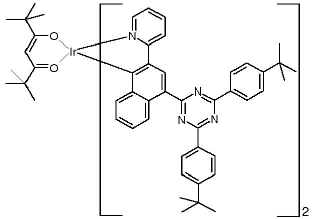 | 29% |
| | | | 300 °C / 80 h / Aceton Xylol | |
| Ir(L68)₂(CL2) | L68 | CL2 | 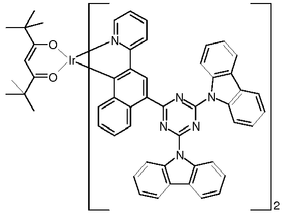 | 26% |
| | | | 300 °C / 60 h / Aceton Xylol | |
| Ir(L80)₂(CL2)* | L80 | CL2 | 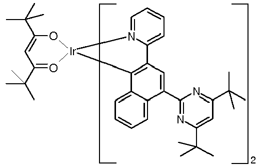 | 21% |
| | | | 300 °C / 60 h / Ethylacetat Mesitylen | |
| Ir(L80)₂(CL3)* | L80 | 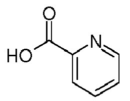 98-98-6 CL3 | 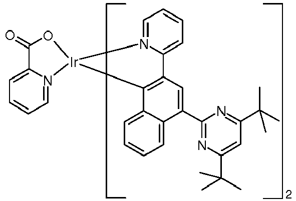 | 19% |
| | | | 290 °C / 60 h / Ethylacetat Mesitylen | |
| Ir(L1 )₂(CL3) | L1 | CL3 | 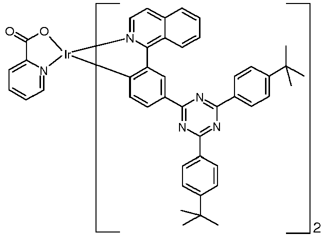 | 27% |
| | | | 260 °C / 60 h / Aceton Toluol | |
| Ir(L10)₂(CL3) | L10 | CL3 | 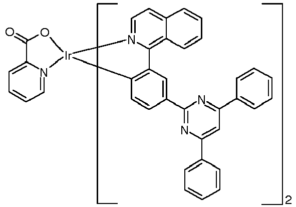 | 29% |
| | | | 260 °C / 60 h / Aceton Xylol | |
| Ir(L39)₂(CL3)* | L39 | CL3 | 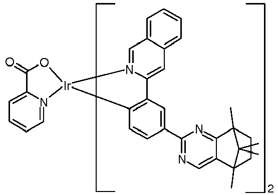 | 26% |
| | | | 260 °C / 80 h / Ethylacetat Xylol | |
| Ir(L52)₂(CL3)* | L52 | CL3 | 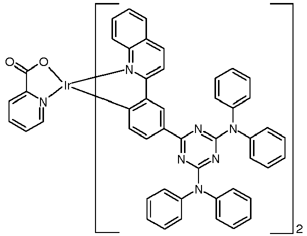 | 23% |
| | | | 300 °C / 80 h / Aceton Xylol | |
| Ir(L55)₂(CL4) | L55 | 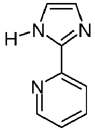 | 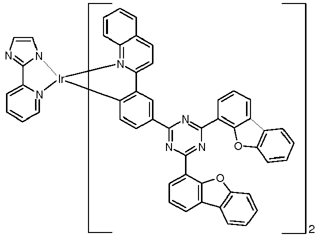 | 27% |
| | | 18653-75-3 | | |
| | | CL4 | 300 °C / 80 h / Aceton Xylol | |
| Ir(L61)₂(CL4)* | L61 | CL4 | 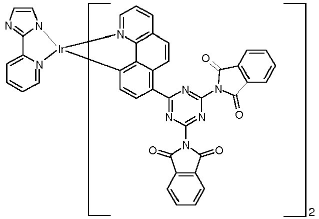 | 21% |
| | | | 260 °C / 80 h / Ethylacetat Mesitylen | |

| | | | | |
|---|---|---|---|---|
| * nicht erfindungsgemäß | | | | |

### Variante B:

### Schritt 1:

### Siehe Variante A, Schritt 1.

### Schritt 2:

Das rohe Chloro-Dimer der Formel [Ir(L)₂Cl]₂ wird in 200 ml THF suspendiert, die Suspension wird mit 20 mmol des Co-Liganden CL, 20 mmol Silber(I)-trifluoracetat und 30 mmol Kaliumcarbonat versetzt und 24 h unter Rückfluss erhitzt. Nach Erkalten wird das THF im Vakuum entfernt. Der Rückstand wird in 200 ml eines Gemischs aus Ethanol und konz. Ammoniak-Lösung (1:1, vv) aufgenommen. Die Suspension wird 1 h bei Raumtemperatur gerührt, der Feststoff wird abgesaugt, zweimal mit je 50 ml eines Gemischs aus Ethanol und konz. Ammoniak-Lösung (1:1, vv) und zweimal mit je 50 ml Ethanol gewaschen und dann im Vakuum getrocknet. Heißextraktion und Sublimation wie in Variante A.

| **Bsp.** | **Ligand L** | **Co-Ligand CL** | **Ir-Komplex Schritt 1: Reaktionstemp.** / **Reaktionszeit** / **Suspensionsmittel Schritt 2: Extraktionsmittel** | **Ausbeute** |
|---|---|---|---|---|
| Ir(L4)₂(CL7) | L4 | 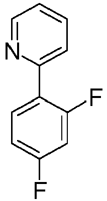 | 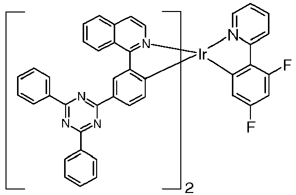 | 39 % |
| | | 391604-55-0 | 280 °C / 60 h / Ethylacetat | |
| | | CL7 | Toluol | |
| Ir(L4)₂(CL8) | L4 | 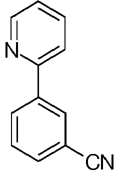 | 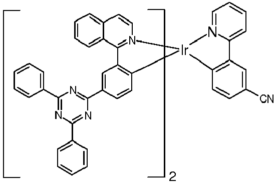 | 21 % |
| | | 4350-51-0 | 270 °C / 48 h / Aceton | |
| | | CL8 | Xylol | |

### Variante C:

### Schritt 1:

### Siehe Variante A, Schritt 1.

### Schritt 2:

Das rohe Chloro-Dimer der Formel [Ir(L)₂Cl]₂ wird in 1000 ml Dichlormethan und 150 ml Ethanol suspendiert, die Suspension wird mit 20 mmol Silber(I)-trifluormethansulfonat versetzt und 24 h bei Raumtemperatur gerührt. Man saugt vom ausgefallen Feststoff (AgCI) über eine kurzes Celite-Bett ab und engt das Filtrat im Vakuum zur Trockene ein. Der so erhaltene Feststoff wird in 100 ml Ethylenglykol aufgenommen, mit 20 mmol des Co-Liganden CL versetzt und dann 30 h bei 130 °C gerührt. Nach Erkalten saugt man vom Feststoff ab, wäscht diesen zweimal mit je 50 ml Ethanol und trocknet im Vakuum. Heißextraktion und Sublimation wie in Variante A.

| **Bsp.** | **Ligand L** | **Co-Ligand CL** | **Ir-Komplex Schritt 1: Reaktionstemp.** / **Reaktionszeit** / **Suspensionsmittel Schritt 2: Extraktionsmittel** | **Ausbeute** |
|---|---|---|---|---|
| Ir(L47)₂(CL11)* | L47 | 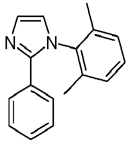 | 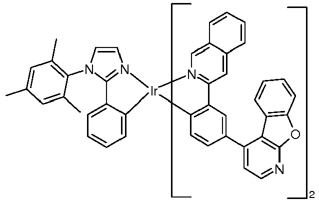 | 46 % |
| | | 914306-48-2 CL11 | 300 °C / 80 h / Aceton Xylol | |

| | | | | |
|---|---|---|---|---|
| * nicht erfindungsgemäß | | | | |

### Variante E:

Ein Gemisch aus 10 mmol des Ir-Komplexes Ir(L)₂(CL1 oder CL2) und 20 mmol des Liganden L' und ein glasummantelter Magnetrührkern werden unter Vakuum (10⁻⁵ mbar) in eine 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Weitere Aufarbeitung, Reinigung und Sublimation wie unter 1) Homoleptische tris-faciale Iridium-Komplexe beschrieben.

| **Bsp.** | **Ir-Komplex Ir(L)₂(CL)** | **Ligand L'** | **Ir-Komplex Schritt 1: Reaktionstemp. / Reaktionszeit / Suspensionsmittel Schritt 2: Extraktionsmittel** | **Ausbeute** |
|---|---|---|---|---|
| Ir(L4)₂(L31) | Ir(L4)₂(CL2) | L31 | 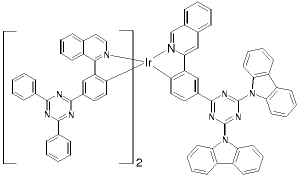 | 39 % |
| | | | 280 °C / 80 h / DCM Mesitylen | |
| Ir(L8)₂(L30)* | Ir(L8)₂(CL3) | L30 | 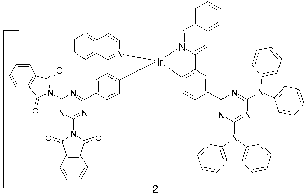 | 43 % |
| | | | 300 °C / 70 h / DCM Mesitylen | |

| | | | | |
|---|---|---|---|---|
| * nicht erfindungsgemäß | | | | |

### Physikalische Eigenschaften der Verbindungen und organische Elektrolumineszenzvorrichtungen

### Beispiel 1: Photolumineszenz in Lösung

Die erfindungsgemäßen Komplexe können in Toluol gelöst werden. Die Kenndaten von Photolumineszenzspektren toluolischer Lösungen der Komplexe aus Tabelle 1 sind in Tabelle 2 aufgeführt. Dabei werden Lösungen mit einer Konzentration von etwa 1 mg/ml verwendet und die optische Anregung im lokalen Absorptionsmaximum durchgeführt (bei ca. 450 nm).

**Tabelle 1: Strukturen in Photolumineszenz untersuchter erfindungsgemäßer Komplex sowie zugehöriger Vergleichskomplexe. Die Zahlen in eckigen Klammern geben dabei die entsprechende CAS-Nummer an. Die Synthese von Komplexen ohne CAS-Nummer ist in den genannten Patentanmeldungen beschrieben.**

| | |
|---|---|
| 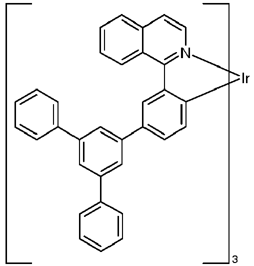 | 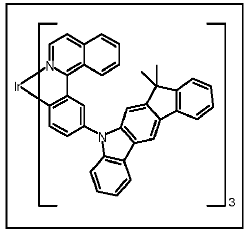 |
| WO 2011/032626 | [1346011-00-4] |
| V1 | V2 |
| 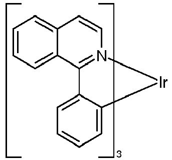 | 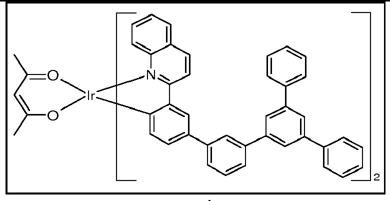 |
| [435293-93-9] | WO 2011/032626 |
| V3 | V4 |
| 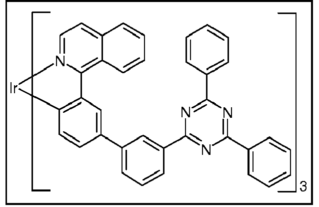 | |
| WO 2011/032626 | |
| V5 | |
| 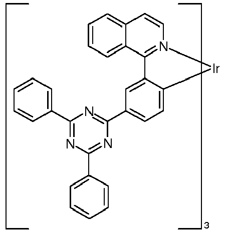 | 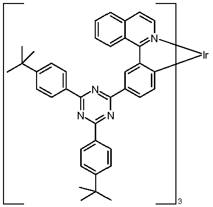 |
| Ir(L3)₃ | Ir(L1)₃ |
| 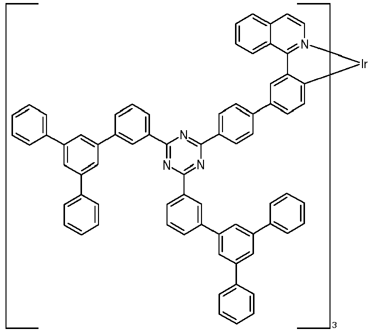 | 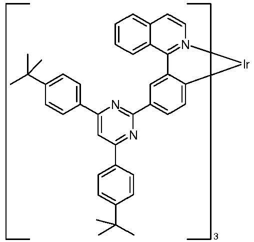 |
| Ir(L74)₃ | Ir(L27)₃ |

**Tabelle 2: Photolumineszenz-Kenndaten**

| | Emission max. (nm) |
|---|---|
| V1 | 621 |
| V2 | 618 |
| V3 | 618 |
| V4 | 598 |
| V5 | 619 |
| Ir(L3)₃ | 596 |
| Ir(L1)₃ | 600 |
| Ir(L74)₃ | 617 |
| Ir(L27)₃ | 612 |

Die erfindungsgemäßen Komplexe können aus Lösung verarbeitet werden. Im Gegensatz dazu ist der unsubstituierte Vergleichskomplex V3 in für die OLED-Herstellung gängigen Lösungsmitteln so unlöslich, dass hiermit keine Vergleichsbauteile hergestellt werden können.

### Beispiel 2: Herstellung der OLEDs

Die erfindungsgemäßen Komplexe können aus Lösung verarbeitet werden und führen gegenüber vakuumprozessierten OLEDs zu wesentlich einfacher herstellbaren OLEDs mit dennoch guten Eigenschaften. Die Herstellung vollständig lösungsbasierter OLEDs ist in der Literatur bereits vielfach beschrieben, z.B. in WO 2004/037887. Die Herstellung vakuumbasierter OLEDs ist ebenfalls vielfach vorbeschrieben, u.a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und in den darauffolgenden Schichten (Lochblockierschicht und Elektronentransportschicht) aus dem Vakuum erfolgt. Die vorbeschriebenen allgemeinen Verfahren werden dafür wie folgt auf die hier beschriebenen Gegebenheiten (Schichtdickenvariation, Materialien) angepasst und kombiniert:
Der Aufbau ist wie folgt:
- Substrat,
- ITO (50 nm),
- PEDOT:PSS (60 nm),
- Lochtransportschicht (HTL) (20 nm),
- Emissionsschicht (EML) (60 nm),
- Lochblockierschicht (HBL) (10 nm)
- Elektronentransportschicht (ETL) (40 nm),
- Kathode.

Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausgeheizt, um Restwasser zu entfernen. Auf diese beschichteten Glasplättchen werden die Interlayer sowie die Emissionsschicht aufgebracht. Die verwendete Lochtransportschicht ist vernetzbar. Es wird ein Polymer der im Folgenden gezeigten Struktur verwendet, das gemäß WO 2010/097155 synthetisiert werden kann:

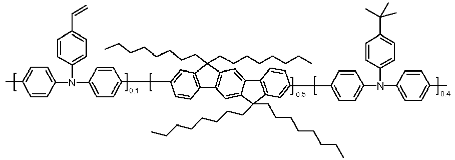

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 18 g/l, wenn, wie hier, die für eine Device typische Schichtdicke von 60nm mittels Spincoating erzielt werden soll. Die Schichten werden in einer Inertgasatmosphäre, im vorliegenden Fall Argon, aufgeschleudert und 10 Minuten bei 160°C aus geheizt. Die im vorliegenden Fall verwendeten Materialien sind in Tabelle 3 gezeigt.

**Tabelle 3: Verwendete EML-Materialien**

| | | |
|---|---|---|
| 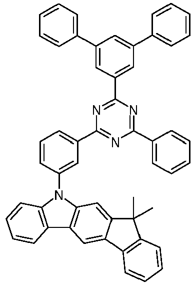 | 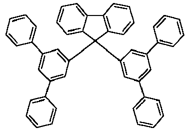 | 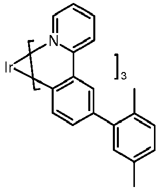 |
| TMM-A | TMM-B | Co-Dotand C |

Die Materialien für die Lochblockierschicht und Elektronentransportschicht werden in einer Vakuumkammer thermisch aufgedampft. Dabei kann z.B. die Elektronentransportschicht aus mehr als einem Material bestehen, die einander durch Co-Verdampfung in einem bestimmten Volumenanteil beigemischt werden. Eine Angabe wie ETM1 :ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 4 gezeigt.

**Tabelle 4: Verwendete HBL- und ETL-Materialien**

| | |
|---|---|
| 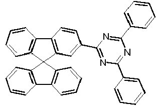 | 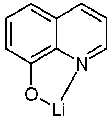 |
| ETM1 | ETM2 |

Die Kathode wird durch die thermische Verdampfung einer 100 nm Aluminiumschicht gebildet. Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'-schen Abstrahlcharakteristik sowie die (Betriebs-)Lebensdauer bestimmt. Aus den IUL-Kennlinien werden Kennzahlen bestimmt wie die Betriebsspannung (in V) und die Effizienz (cd/A) bei einer bestimmten Helligkeit. Die Elektrolumineszenzspektren werden bei einer Leuchtdichte von 1000 cd/m² gemessen und daraus die CIE 1931 x und y Farbkoordinaten berechnet. LD80 @ 8000 cd/m2 ist die Lebensdauer, bis die OLED bei einer Starthelligkeit von 8000 cd/m² auf 80 % der Anfangsintensität, also auf 6400 cd/m², abgefallen ist.

Die Daten von OLEDs, deren EML aus TMM-A, TMM-B und Dotand D (gemäß Tabelle 1) bestehen, sind in Tabelle 5 gezeigt. Dabei wird ETM-1 als HBL und ETM1 :ETM2 (50%:50%) als ETL verwendet.

**Tabelle 5: Ergebnisse lösungsprozessierter OLEDs mit EML-Mischungen vom Typ x% TMM-A, (100-x-y)% TMM-B, y % Dotand D**

| Dotand D | % D | % TMM-A | Effizienz bei 1000 cd/m² | Spannung bei 1000 cd/m² | CIE x/y bei 1000 cd/m² | | LD80 bei 8000 cd/m² |
|---|---|---|---|---|---|---|---|
| | | | cd/A | [V] | x | y | [h] |
| V2 | 6 | 40 | 6.9 | 9.8 | 0.67 | 0.33 | 2 |
| Ir(L3)₃ | 6 | 40 | 10.9 | 8.1 | 0.63 | 0.37 | 2 |

Die Daten von OLEDs, deren EML aus 30% TMM-A, 34% TMM-B, 30% Co-Dotand C und 6 % Dotand D (gemäß Tabelle 1) bestehen, sind in Tabelle 6 gezeigt. Dabei wurde ETM-1 als HBL und ETM1 :ETM2 (50%:50%) als ETL verwendet.

**Tabelle 6: Ergebnisse lösungsprozessierter OLEDs mit EML-Mischungen vom Typ 30% TMM-A, 34% TMM-B, 30% Co-Dotand C, 6 % Dotand D**

| Dotand D | Effizienz bei 1000 cd/m² | Spannung bei 1000 cd/m² | CIE x/y bei 1000 cd/m² | | LD80 bei 8000 cd/m² |
|---|---|---|---|---|---|
| | cd/A | [V] | x | y | [h] |
| V1 | 13.1 | 5.7 | 0.66 | 0.34 | 382 |
| V2 | 14.0 | 6.7 | 0.65 | 0.35 | 467 |
| V4 | 21.2 | 7.4 | 0.62 | 0.38 | 24 |
| V5 | 13.7 | 6.1 | 0.65 | 0.35 | 311 |
| Ir(L3)₃ | 25.3 | 6.0 | 0.61 | 0.39 | 704 |

## Patentansprüche

1. Verbindung gemäß Formel (1),
Ir(L)ₙ(L')ₘ Formel (1)
welche eine Teilstruktur M(L)ₙ der Formel (2) enthält: 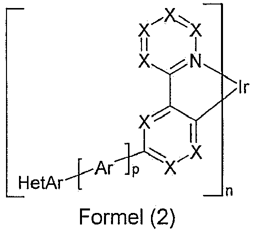 wobei für die verwendeten Symbole und Indizes gilt:
HetAr ist eine Gruppe gemäß einer der Formeln (HetAr-1a) bis (HetAr-4a), 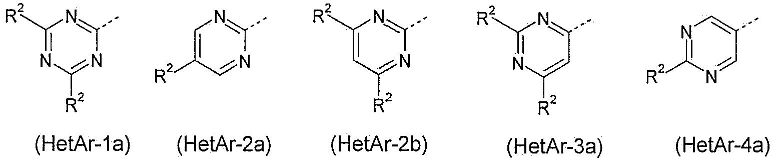 wobei die gestrichelte Bindung die Bindung dieser Gruppe an den Liganden bzw. an Ar andeutet und wobei R² gleich oder verschieden bei jedem Auftreten für ein aromatisches oder heteroaromatisches Ringsystem mit 6 bis 24 aromatischen Ringatomen steht, das jeweils durch einen oder mehrere Reste R³ substituiert sein kann;
X ist bei jedem Auftreten CR¹ oder N, mit der Maßgabe, dass maximal zwei Gruppen X pro Cyclus für N stehen, oder zwei direkt aneinander gebundene Gruppen X stehen für eine Gruppe der Formel (3) oder zwei benachbarte Gruppen X an den beiden unterschiedlichen Cyclen stehen für eine Gruppe der folgenden Formel (4), 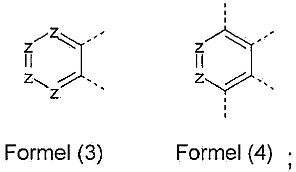 wobei die gestrichelten Bindungen die Verknüpfung dieser Gruppe im Liganden andeuten;
mit der Maßgabe, dass die Teilstruktur der Formel (2) mindestens eine Gruppe der Formel (3) oder (4) enthält;
Z ist bei jedem Auftreten CR¹ oder N, mit der Maßgabe, dass maximal zwei Gruppen Z für N stehen;
Ar ist eine para-Phenylengruppe, die mit einem oder mehreren Resten R¹ substituiert sein kann;
R¹ ist bei jedem Auftreten gleich oder verschieden H, D, F, Cl, Br, I, N(R³)₂, CN, NO₂, OH, COOH, C(=O)N(R³)₂, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, C=O, NR³, O, S oder CONR³ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann; dabei können zwei benachbarte Reste R¹ bzw. zwei benachbarte Reste R² auch miteinander ein mono- oder polycyclisches, aliphatisches, aromatisches oder heteroaromatisches Ringsystem bilden;
R³ ist bei jedem Auftreten gleich oder verschieden H, D, F oder eine aliphatische, aromatische und/oder heteroaromatische Gruppe mit 1 bis 20 C-Atomen, in der auch ein oder mehrere H-Atome durch F ersetzt sein können; dabei können zwei oder mehrere Substituenten R³ auch miteinander ein mono- oder polycyclisches, aliphatisches Ringsystem bilden;
L' ist gleich oder verschieden bei jedem Auftreten ein bidentater, monoanionischer Ligand;
n ist 1, 2 oder 3;
m ist (3 - n);
p ist 0 oder 1.

2. Verbindung nach Anspruch 1, **dadurch gekennzeichnet, dass** die Teilstruktur der Formel (2) ausgewählt ist aus den Strukturen der Formeln (5) bis (9), 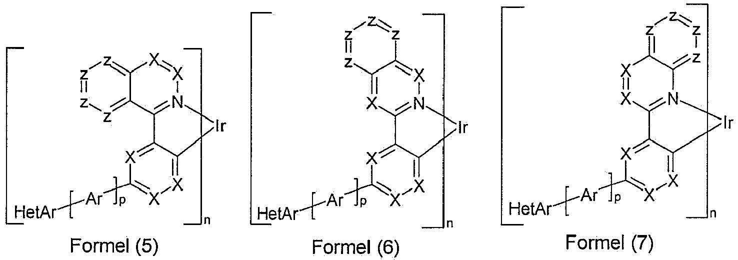 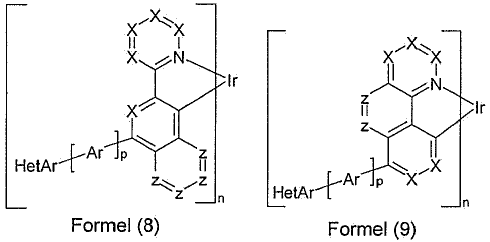 wobei die verwendeten Symbole und Indizes die in Anspruch 1 genannten Bedeutungen aufweisen.

3. Verbindung nach Anspruch 1 oder 2, **dadurch gekennzeichnet, dass** maximal eine Gruppe X pro Cyclus für N steht und dass maximal eine Gruppe Z für N steht.

4. Verbindung nach einem oder mehreren der Ansprüche 1 bis 3, **dadurch gekennzeichnet, dass** die Teilstruktur der Formel (2) ausgewählt ist aus den Formeln (5a) bis (9a), 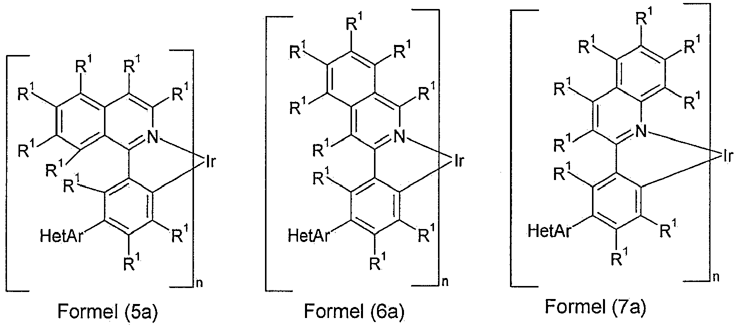 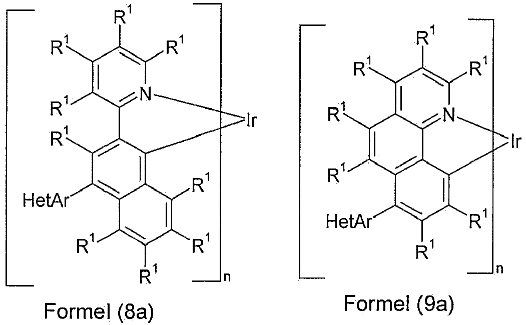 wobei die verwendeten Symbole und Indizes die in Anspruch 1 genannten Bedeutungen aufweisen.

5. Verbindung nach einem oder mehreren der Ansprüche 2 bis 4, **dadurch gekennzeichnet, dass** in Verbindungen enthaltend eine Teilstruktur der Formel (7), (7a), (8) und (8a) n = 2 ist und L' für einen nicht-ortho-metallierten Liganden, insbesondere für die Diketonat, steht, und dass in Verbindungen enthaltend eine Teilstruktur der Formeln (5), (6), (9), (5a), (6a) und (9a) n = 3 ist oder n = 2 ist und L' für einen ortho-metallierten Liganden steht.

6. Verbindung nach einem oder mehreren der Ansprüche 1 bis 5, **dadurch gekennzeichnet, dass** die Reste R¹ bei jedem Auftreten gleich oder verschieden ausgewählt sind aus der Gruppe bestehend aus H, D, F, N(R³)₂, CN, B(OR³)₂, C(=O)R³, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R³ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R³ substituiert sein kann; dabei können zwei benachbarte Reste R¹ auch miteinander ein mono- oder polycyclisches, aliphatisches oder aromatisches Ringsystem bilden.

7. Verbindung nach einem oder mehreren der Ansprüche 1 bis 6, **dadurch gekennzeichnet, dass** L' monoanionische bidentate Liganden sind, die über ein Stickstoffatom und ein Kohlenstoffatom oder über zwei Sauerstoffatome oder über zwei Stickstoffatome oder über ein Stickstoffatom und ein Sauerstoffatom an das Iridium binden.

8. Verfahren zur Herstellung einer Verbindung nach einem oder mehreren der Ansprüche 1 bis 7 durch Umsetzung einer Verbindung mit einer Struktur nach einem oder mehreren der Ansprüche 1 bis 7, die statt der Gruppe HetAr eine reaktive Abgangsgruppe aufweist, mit einer Gruppe HetAr-Hal, wobei Hal für F, Cl, Br oder I steht; oder durch Umsetzung der freien Liganden L und gegebenenfalls L' mit Iridiumalkoholaten der Formel (40), mit Iridiumketoketonaten der Formel (41), mit Iridiumhalogeniden der Formel (42), mit dimeren Iridiumkomplexen der Formel (43) oder mit Iridiumkomplexen der Formel (44) oder Iridiumverbindungen, die sowohl Alkoholat- und/oder Halogenid- und/oder Hydroxywie auch Ketoketonatreste tragen,
Ir(OR¹)ₙ Formel (40) 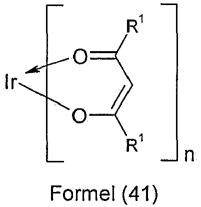
IrHalₙ Formel (42) 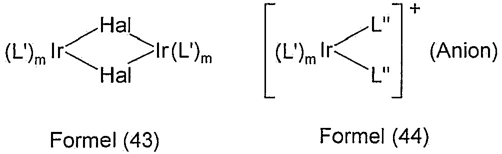
wobei die Symbole und Indizes m, n und R¹ die in Anspruch 1 angegebenen Bedeutungen haben, Hal = F, Cl, Br oder I ist, L" für einen Alkohol oder ein Nitril steht und (Anion) ein nicht-koordinierendes Anion ist.

9. Formulierung, enthaltend mindestens eine Verbindung nach einem oder mehreren der Ansprüche 1 bis 7 und mindestens ein Lösemittel und/oder eine weitere organische oder anorganische Verbindung.

10. Verwendung einer Verbindung nach einem oder mehreren der Ansprüche 1 bis 7 in einer elektronischen Vorrichtung.

11. Elektronische Vorrichtung enthaltend mindestens eine Verbindung nach einem oder mehreren der Ansprüche 1 bis 7.

12. Elektronische Vorrichtung nach Anspruch 11, **dadurch gekennzeichnet, dass** es sich um eine organische Elektrolumineszenzvorrichtung handelt und die Verbindung nach einem oder mehreren der Ansprüche 1 bis 7 als emittierende Verbindung in einer oder mehreren emittierenden Schichten eingesetzt wird.

## Claims

1. Compound of formula (1)
Ir(L)ₙ(L')ₘ formula (1)
containing a substructure M(L)ₙ of the formula (2): 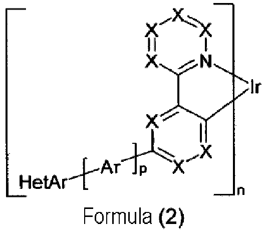 where the symbols and indices used are as follows:
HetAr is a group of one of the formulae (HetAr-1a) to (HetAr-4a): 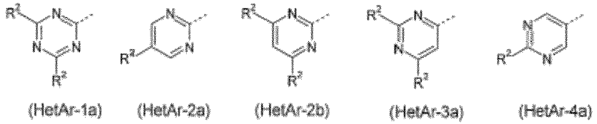 where the dotted bond indicates the bond of this group to the ligand or to Ar and where R² is the same or different at each instance and is an aromatic or heteroaromatic ring system which has 6 to 24 aromatic ring atoms and may be substituted in each case by one or more R³ radicals;
X at each instance is CR¹ or N, with the proviso that not more than two X groups per cycle are N or two X groups bonded directly to one another are a group of the formula (3) or two adjacent X groups on the two different cycles are a group of the following formula (4): 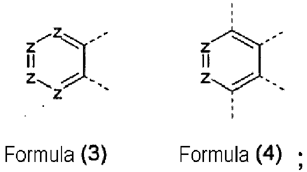 where the dotted bonds indicate the linkage of this group in the ligand;
with the proviso that the substructure of the formula (2) contains at least one group of the formula (3) or (4);
Z at each instance is CR¹ or N, with the proviso that not more than two Z groups are N;
Ar is a para-phenylene group which may be substituted by one or more R¹ radicals;
R¹ is the same or different at each instance and is H, D, F, Cl, Br, I, N(R³)₂, CN, NO₂, OH, COOH, C(=O)N(R³)₂, B(OR³)₂, C(=O)R³, P(=O)(R³)2, S(=O)R³, S(=O)₂R³, OSO₂R³, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, each of which may be substituted by one or more R³ radicals, where one or more nonadjacent CH₂ groups may be replaced by R³C=CR³, C≡C, Si(R³)₂, C=O, NR³, O, S or CONR³ and where one or more hydrogen atoms may be replaced by D, F, Cl, Br, I or CN, or an aromatic or heteroaromatic ring system which has 5 to 60 aromatic ring atoms and may be substituted in each case by one or more R³ radicals, or an aryloxy or heteroaryloxy group which has 5 to 40 aromatic ring atoms and may be substituted by one or more R³ radicals, or an aralkyl or heteroaralkyl group which has 5 to 40 aromatic ring atoms and may be substituted by one or more R³ radicals, or a diarylamino group, diheteroarylamino group or arylheteroarylamino group which has 10 to 40 aromatic ring atoms and may be substituted by one or more R³ radicals; at the same time, two adjacent R¹ radicals or two adjacent R² radicals together may also form a mono- or polycyclic, aliphatic, aromatic or heteroaromatic ring system;
R³ is the same or different at each instance and is H, D, F or an aliphatic, aromatic and/or heteroaromatic group having 1 to 20 carbon atoms, in which one or more hydrogen atoms may also be replaced by F; at the same time, two or more R³ substituents together may also form a mono- or polycyclic aliphatic ring system;
L' is the same or different at each instance and is a bidentate, monoanionic ligand;
n is 1, 2 or 3;
m is (3 - n);
p is 0 or 1.

2. Compound according to Claim 1, **characterized in that** the substructure of the formula (2) is selected from the structures of the formulae (5) to (9) 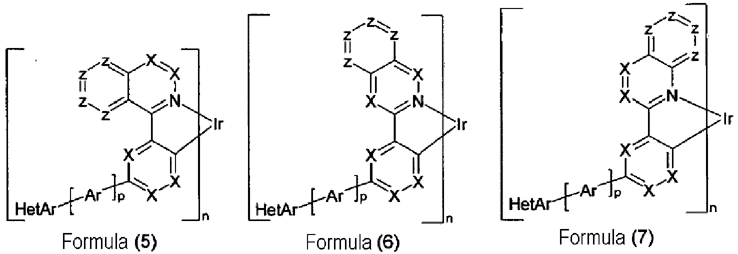 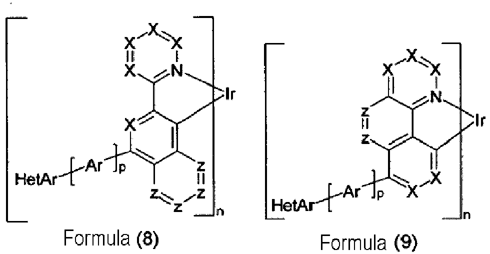 where the symbols and indices used have the definitions given in Claim 1.

3. Compound according to Claim 1 or 2, **characterized in that** not more than one X group per cycle is N and **in that** not more than one Z group is N.

4. Compound according to one or more of Claims 1 to 3, **characterized in that** the substructure of the formula (2) is selected from the formulae (5a) to (9a) 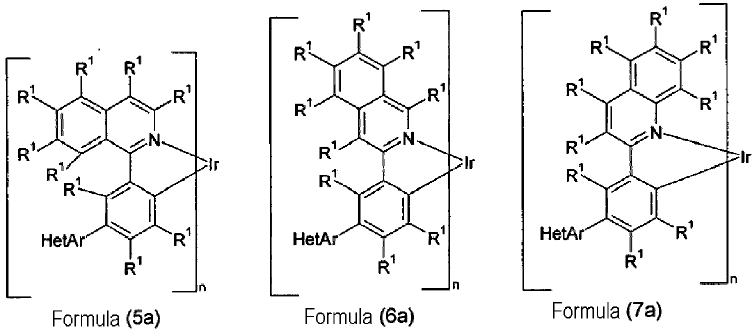 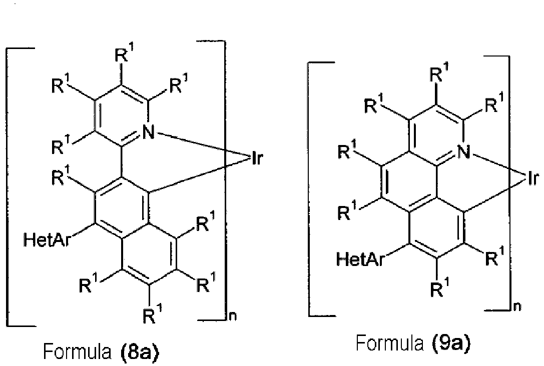 where the symbols and indices used have the definitions given in Claim 1.

5. Compound according to one or more of Claims 2 to 4, **characterized in that**, in compounds containing a substructure of the formula (7), (7a), (8) and (8a), n = 2 and L' is a non-ortho-metalated ligand, especially the diketonate, and **in that**, in compounds containing a substructure of the formulae (5), (6), (9), (5a), (6a) and (9a), n = 3 or n = 2 and L' is an ortho-metalated ligand.

6. Compound according to one or more of Claims 1 to 5, **characterized in that** the R¹ radicals are the same or different at each instance and are selected from the group consisting of H, D, F, N(R³)₂, CN, B(OR³)₂, C(=O)R³, a straight-chain alkyl group having 1 to 10 carbon atoms or an alkenyl group having 2 to 10 carbon atoms or a branched or cyclic alkyl group having 3 to 10 carbon atoms, each of which may be substituted by one or more R³ radicals, where one or more hydrogen atoms may be replaced by D or F, or an aromatic or heteroaromatic ring system which has 5 to 30 aromatic ring atoms and may be substituted in each case by one or more R³ radicals; at the same time, two adjacent R¹ radicals together may also form a mono- or polycyclic, aliphatic or aromatic ring system.

7. Compound according to one or more of Claims 1 to 6, **characterized in that** L' are monoanionic bidentate ligands bonded to the iridium via one nitrogen atom and one carbon atom or via two oxygen atoms or via two nitrogen atoms or via one nitrogen atom and one oxygen atom.

8. Process for preparing a compound according to one or more of Claims 1 to 7 by reacting a compound which has a structure according to one or more of Claims 1 to 7 and has a reactive leaving group rather than the HetAr group with a HetAr-Hal group where Hal is F, Cl, Br or I; or by reacting the free ligands L and optionally L' with iridium alkoxides of the formula (40), with iridium ketoketonates of the formula (41), with iridium halides of the formula (42), with dimeric iridium complexes of the formula (43) or with iridium complexes of the formula (44) or with iridium compounds bearing both alkoxide and/or halide and/or hydroxyl radicals and ketoketonate radicals
Ir(OR¹)ₙ Formula (40) 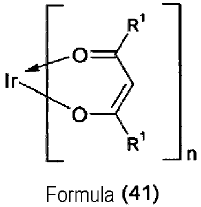
IrHalₙ Formula (42) 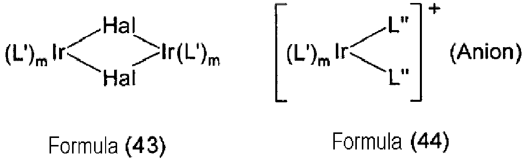
where the symbols and indices m, n and R¹ have the definitions given in Claim 1, Hal = F, Cl, Br or I, L" is an alcohol or a nitrile and (Anion) is a non-coordinating anion.

9. Formulation comprising at least one compound according to one or more of Claims 1 to 7 and at least one solvent and/or a further organic or inorganic compound.

10. Use of a compound according to one or more of Claims 1 to 7 in an electronic device.

11. Electronic device comprising at least one compound according to one or more of Claims 1 to 7.

12. Electronic device according to Claim 11, **characterized in that** it is an organic electroluminescent device and the compound according to one or more of Claims 1 to 7 is used as emitting compound in one or more emitting layers.

## Revendications

1. Composé selon la formule (1)
Ir(L)ₙ(L')ₘ Formule (1)
qui contient une structure partielle M(L)ₙ de formule (2) : 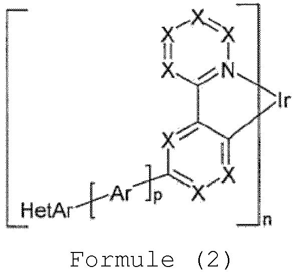 dans laquelle les symboles et les indices utilisés ont les significations suivantes :
HetAr est un groupe selon une des formules (HetAr-1a) à (HetAr-4a) : 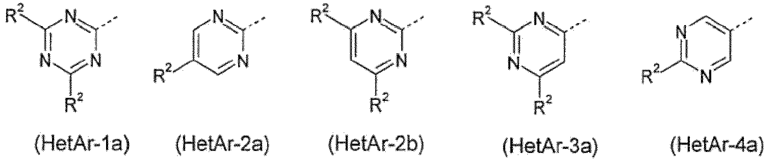 la liaison en pointillés indiquant la liaison de ce groupe au ligand ou à Ar, et les R² représentant de manière identique ou différente à chaque occurrence un système cyclique aromatique ou hétéroaromatique de 6 à 24 atomes de cycle aromatique, qui peut à chaque fois être substitué par un ou plusieurs radicaux R³ ;
les X représentent à chaque occurrence CR¹ ou N, à condition qu'au plus deux groupes X par cycle représentent N, ou deux groupes X directement reliés l'un à l'autre représentent un groupe de formule (3) ou deux groupes X voisins sur les deux cycles différents représentent un groupe de la formule (4) suivante : 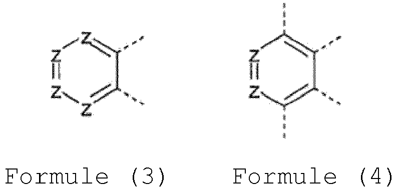 dans lesquelles les liaisons en pointillés indiquent la liaison de ce groupe dans le ligand ;
à condition que la structure partielle de formule (2) contienne au moins un groupe de formule (3) ou (4) ; les Z représentent à chaque occurrence CR¹ ou N, à condition qu'au plus deux groupes Z représentent N ;
Ar représente un groupe para-phénylène, qui peut être substitué avec un ou plusieurs radicaux R¹ ;
les R¹ représentent à chaque occurrence de manière identique ou différente H, D, F, Cl, Br, I, N(R³)₂, CN, NO₂, OH, COOH, C(=O)N(R³)₂, B(OR³)₂, C(=O)R³, P(=O)(R³)₂, S(=O)R³, S(=O)₂R³, OSO₂R³, un groupe alkyle, alcoxy ou thioalcoxy linéaire de 1 à 20 atomes C ou un groupe alcényle ou alcynyle de 2 à 20 atomes C ou un groupe alkyle, alcoxy ou thioalcoxy ramifié ou cyclique de 3 à 20 atomes C, qui peut à chaque fois être substitué avec un ou plusieurs radicaux R³, un ou plusieurs groupes CH₂ non voisins pouvant être remplacés par R³C=CR³, C=C, Si(R³)₂, C=O, NR³, O, S ou CONR³, et un ou plusieurs atomes H pouvant être remplacés par D, F, Cl, Br, I ou CN, ou un système cyclique aromatique ou hétéroaromatique de 5 à 60 atomes de cycle aromatique, qui peut à chaque fois être substitué par un ou plusieurs radicaux R³, ou un groupe aryloxy ou hétéroaryloxy de 5 à 40 atomes de cycle aromatique, qui peut être substitué par un ou plusieurs radicaux R³, ou un groupe aralkyle ou hétéroaralkyle de 5 à 40 atomes de cycle aromatique, qui peut être substitué par un ou plusieurs radicaux R³, ou un groupe diarylamino, un groupe dihétéroarylamino ou un groupe arylhétéroarylamino de 10 à 40 atomes de cycle aromatique, qui peut être substitué par un ou plusieurs radicaux R³ ; dans ce cadre deux radicaux R¹ voisins ou deux radicaux R² voisins pouvant également former l'un avec l'autre un système cyclique mono- ou polycyclique, aliphatique, aromatique ou hétéroaromatique ;
les R³ représentent à chaque occurrence de manière identique ou différente H, D, F, ou un groupe aliphatique, aromatique et/ou hétéroaromatique de 1 à 20 atomes C, dans lequel un ou plusieurs atomes H peuvent également être remplacés par F ; dans ce cadre deux substituants R³ ou plus pouvant également former les uns avec les autres un système cyclique aliphatique mono- ou polycyclique ;
L' représente de manière identique ou différente à chaque occurrence un ligand monoanionique bidentate ;
n représente 1, 2 ou 3 ;
m représente (3-n) ;
p représente 0 ou 1.

2. Composé selon la revendication 1, **caractérisé en ce que** la structure partielle de formule (2) est choisie parmi les structures des formules (5) à (9) : 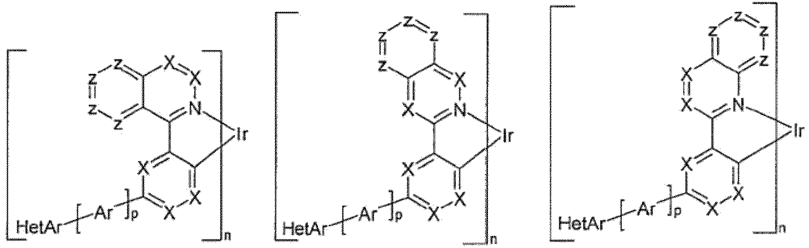 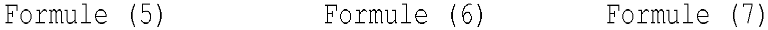 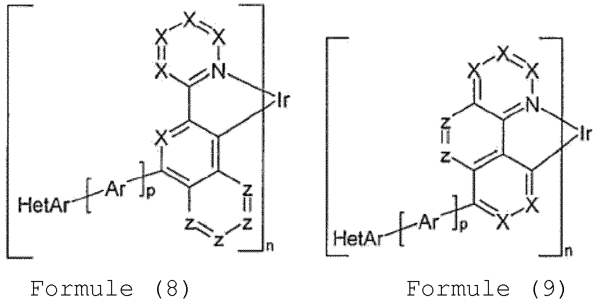 dans lesquelles les symboles et les indices utilisés ont les significations indiquées dans la revendication 1.

3. Composé selon la revendication 1 ou 2, **caractérisé en ce qu'**au plus un groupe X par cycle représente N et **en ce qu'**au plus un groupe Z représente N.

4. Composé selon une ou plusieurs des revendications 1 à 3, **caractérisé en ce que** la structure partielle de formule (2) est choisie parmi les formules (5a) à (9a) : 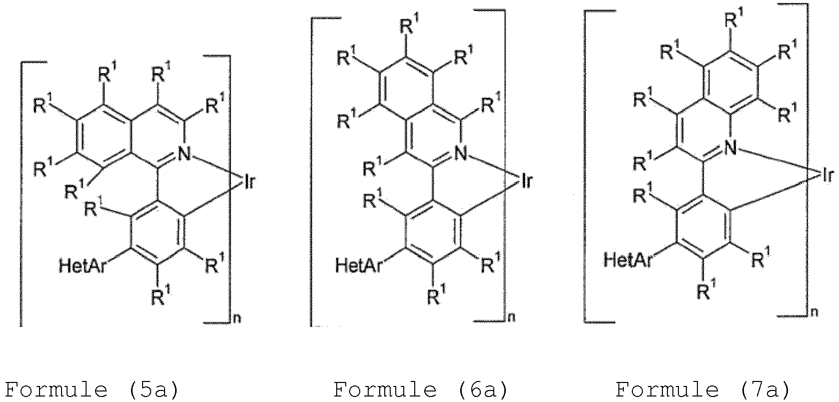 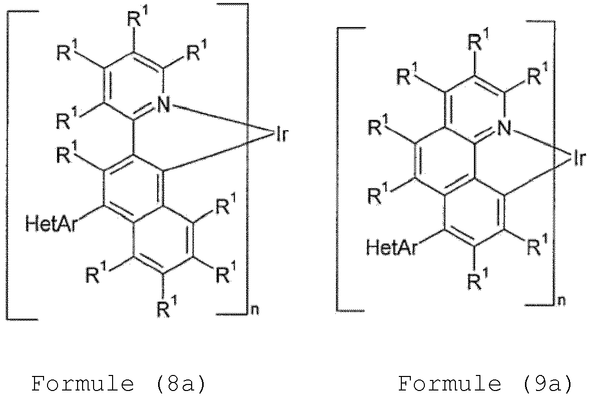 dans lesquelles les symboles et les indices utilisés ont les significations indiquées dans la revendication 1.

5. Composé selon une ou plusieurs des revendications 2 à 4, **caractérisé en ce que**, dans des composés contenant une structure partielle des formules (7), (7a), (8) et (8a), n = 2 et L' représente un ligand non-ortho-métallisé, notamment le dicétonate et **en ce que**, dans des composés contenant une structure partielle des formules (5), (6), (9), (5a), (6a) et (9a), n = 3 ou n = 2 et L' représente un ligand ortho-métallisé.

6. Composé selon une ou plusieurs des revendications 1 à 5, **caractérisé en ce que** les radicaux R¹ sont choisis à chaque occurrence de manière identique ou différente dans le groupe constitué par H, D, F, N(R³)₂, CN, B(OR³)₂, C(=O)R³, un groupe alkyle linéaire de 1 à 10 atomes C ou un groupe alcényle de 2 à 10 atomes C ou un groupe alkyle ramifié ou cyclique de 3 à 10 atomes C, qui peut à chaque fois être substitué avec un ou plusieurs radicaux R³, un ou plusieurs atomes H pouvant être remplacés par D ou F, ou un système cyclique aromatique ou hétéroaromatique de 5 à 30 atomes de cycle aromatique, qui peut à chaque fois être substitué par un ou plusieurs radicaux R³ ; dans ce cadre deux radicaux R¹ voisins pouvant également former l'un avec l'autre un système cyclique mono- ou polycyclique, aliphatique ou aromatique.

7. Composé selon une ou plusieurs des revendications 1 à 6, **caractérisé en ce que** les L' sont des ligands monoanioniques bidentates, qui sont reliés à l'iridium par un atome d'azote et un atome de carbone ou par deux atomes d'oxygène ou par deux atomes d'azote ou par un atome d'azote et un atome d'oxygène.

8. Procédé de fabrication d'un composé selon une ou plusieurs des revendications 1 à 7 par mise en réaction d'un composé ayant une structure selon une ou plusieurs des revendications 1 à 7 qui comprend au lieu du groupe HetAr un groupe partant réactif, avec un groupe HetAr-Hal, Hal représentant F, Cl, Br ou I ; ou par mise en réaction des ligands libres L et éventuellement L' avec des alcoolates d'iridium de formule (40), avec des cétocétonates d'iridium de formule (41), avec des halogénures d'iridium de formule (42), avec des complexes d'iridium dimères de formule (43) ou avec des complexes d'iridium de formule (44) ou des composés d'iridium qui portent aussi bien des radicaux alcoolate et/ou halogénure et/ou hydroxy que cétocétonate
Ir(OR¹)ₙ Formule (40) 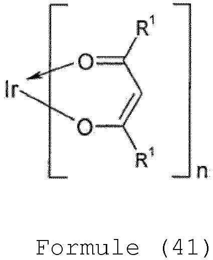
IrHalₙ Formule (42) 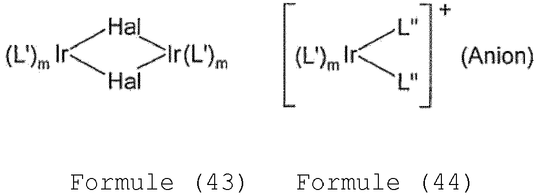
dans lesquelles les symboles et les indices m, n et R¹ ont les significations indiquées dans la revendication 1, Hal = F, Cl, Br ou I, L" représente un alcool ou un nitrile, et (Anion) représente un anion non coordinant.

9. Formulation, contenant au moins un composé selon une ou plusieurs des revendications 1 à 7 et au moins un solvant et/ou un autre composé organique ou inorganique.

10. Utilisation d'un composé selon une ou plusieurs des revendications 1 à 7 dans un dispositif électronique.

11. Dispositif électronique contenant au moins un composé selon une ou plusieurs des revendications 1 à 7.

12. Dispositif électronique selon la revendication 11, **caractérisé en ce qu'**il s'agit d'un dispositif électroluminescent organique, et le composé selon une ou plusieurs des revendications 1 à 7 est utilisé en tant que composé émetteur dans une ou plusieurs couches d'émission.
